# EUROPEAN PATENT SPECIFICATION

(11) **EP 1 965 255 B1**
(45) Date of publication and mention of the grant of the patent: **12.08.2015**
(21) Application number: 08101959.8
(22) Date of filing: 25.02.2008
(51) Int. Cl.: G03F 7/00

(54) **Color filter and method for making the color filter**
Farbfilter und Verfahren zur Herstellung des Farbfilters
Filtre couleur et procédé de fabrication du filtre couleur

(30) Priority: 27.02.2007 JP 2007047540
(43) Date of publication of application: 03.09.2008
(73) Proprietor: FUJIFILM Corporation, Minato-ku Tokyo 106-8620 (JP)
(72) Inventor: Takakuwa, Hideki, Haibara-gun, Shizuoka-ken, Kanagawa (JP); Shimada, Kazuto, Haibara-gun, Shizuoka-ken, Shizuoka (JP); Nakashima, Taeko, Ashigarakami-gun, Kanagawa (JP)
(74) Representative: Brookes Batchellor LLP

(56) References cited:
- EP-A- 1 571 469
- JP-A- 2006 276 878

## Description

### BACKGROUND OF THE INVENTION

### Field of the Invention

The present invention relates to a colored photosensitive composition, a color filter including the same, and a method for making the color filter, wherein the colored photosensitive composition is suitable for forming colored images in color filters used for liquid crystal display devices and solid-state image pickup devices such as CCD and CMOS.

A dying method, a printing method, an electrodeposition method and a pigment dispersion method are known as methods of preparing a color filter that is used for liquid crystal display devices and solid-state image pickup devices.

Among these, the pigment dispersion method is a method where a color filter is prepared by photolithography with a colored photosensitive composition in which a pigment is dispersed in various kinds of photosensitive compositions and, since a pigment is used, this method is advantageous in terms of stability with respect to light and heat. Furthermore, since the photolithographic method is used for patterning, the method has high positioning precision, and has hitherto been widely used as a preferable method for producing color filters for large screens and high definition color displays.

When preparing a color filter by means of the pigment dispersion method, a photosensitive composition is applied to a glass substrate using a spin coater or a roll coater and dried to form a coated film and then the coated film is pattern-wise exposed and developed to form colored pixels. These steps are repeated for respective colors to obtain a color filter. As such a pigment dispersion method, a method that uses a negative type photosensitive composition containing an alkali-soluble resin in combination with a photopolymerizable monomer and a photopolymerization initiator has been described (see, for example, Japanese Patent Application Laid-Open (JP-A) No. 2-199403).

In recent years, color filters for solid-state image pickup devices are required to have higher definition and smaller thickness. For example, as a technology for forming a thin film while maintaining spectral characteristics, there is disclosed a technique of increasing the content of coloring agents to the total solid content in the colored photosensitive composition to improve pattern forming properties by the use of a resin (for example, see Japanese Patent Application Laid-Open (JP-A) No. 2006-276878).

### SUMMARY OF THE INVENTION

The present invention has been made in view of the above circumstances and provides a color filter, made by applying a colored photosensitive composition onto a support to form a colored photosensitive composition layer; exposing the colored photosensitive composition layer with light through a mask; and developing the exposed colored photosensitive composition layer to form a pattern on the support,
wherein the colored photosensitive composition comprises coloring agent(s) at a ratio of 50% by mass to 80% by mass with reference to the total solid content, and a resin having an acid value of 1 mg KOH/g to 70 mg KOH/g, and the resin is a polymer compound having at least one unsaturated double bond selected from the structural units represented by the formulae (1) to (3) disclosed below and as set out in appended claim 1.

### DETAILED DESCRIPTION OF THE INVENTION

### (Colored photosensitive composition)

The colored photosensitive composition used in the invention (hereinafter referred to as, "the composition contains at least one coloring agent (A) and at least one resin (B), and may contain other components as necessary. The components of the colored photosensitive composition of the invention are described below in detail.

### (A) Coloring agent

In the invention, known pigments and dyes conventionally used for color filters may be used as the coloring agent with no particular limitation.

### (Pigment)

Examples of the pigment which may be contained in the colored photosensitive composition of the invention may include various kinds of known inorganic pigments and organic pigments. The pigment preferably has a high transmittance. The pigment having a high transmittance refers to pigments having a small absorbance from 600 to 700 nm in the case of a red filter, pigments having a small absorbance from 525 to 575 nm in the case of a green filter, or pigments having a small absorbance from 425 to 475 nm in the case of a blue filter.

Examples of the inorganic pigment include metal compounds such as metal oxides and metal complex salts, and specific examples thereof include metal oxides of iron, cobalt, aluminum, cadmium, lead, copper, titanium, magnesium, chromium, zinc, and antimony, and metal complex oxides of these metals.

Examples of the organic pigment include: C. I. Pigment Yellow 11, 24, 31, 53, 83, 93, 99, 108, 109, 110, 138, 139, 147, 150, 151, 154, 155, 167, 180, 185, and 199; C. I. Pigment Orange 36, 38, 43, and 71; C. I. Pigment Red 81, 105, 122, 149, 150, 155, 171, 175, 176, 177, 209, 220, 224, 242, 254, 255, 264, and 270; C. I. Pigment Violet 19, 23, 32, and 39; C. I. Pigment Blue 1, 2, 15, 15:1, 15:3, 15:6, 16, 22, 60, and 66; C. I. Pigment Green 7, 36, and 37; C. I. Pigment Brown 25 and 28; and C. I. Pigment Black 1 and 7; and carbon black.

In the invention, pigments containing a basic N atom in the structural formula thereof are particularly preferred. Such pigments containing a basic N atom exhibit good dispersibility in the colored photosensitive composition of the invention. The reason is not evident, but is likely due to the high affinity between the polymerizable component and the pigments.

Preferable examples of the pigment used in the invention include, but not limited to, the followings:
C. I. Pigment Yellow 11,24,108, 109, 110, 138, 139, 150, 151, 154, 167, 180, and 185; C. I. Pigment Orange 36 and 71; C. I. Pigment Red 122, 150, 171, 175, 177, 209, 224, 242, 254, 255, and 264; C. I. Pigment Violet 19, 23, and 32; C. I. Pigment Blue 15:1, 15:3, 15:6, 16, 22, 60, and 66; and C. I. Pigment Black 1.

These organic pigments may be used alone or in combination of two or more of them. When two or more of them are used in combination, color purity of the pigment can be improved. For example, in the case of where the colored photosensitive composition of the invention is used for forming a color pattern in a color filter, it is preferable that two or more pigments be combined. This further improves the color purity of the color pattern of the color filter. Specific examples of the pigments and combination of the pigments are listed below.

Examples of the red pigment include an anthraquinone pigment, a perylene pigment, and a diketopyrrolopyrrole pigment, which may be used alone, or at least one of the red pigments may be combined with at least one selected from the group consisting of a disazo yellow pigment, an isoindoline yellow pigment, a quinophthalone yellow pigment, and a perylene red pigment. Examples of the anthraquinone pigment include: C. I. Pigment Red 177; examples of the perylene pigment include C. I. Pigment Red 155 and C. I. Pigment Red 224; and examples of the diketopyrrolopyrrole pigment include C. I. Pigment Red 254. In the invention, the combination of C. I. Pigment Yellow 139 with an anthraquinone pigment, perylene pigment, or diketopyrrolopyrrole pigment is preferred from the viewpoint of color reproducibility.

The mass ratio of the red pigment to the yellow pigment in the combination is preferably from 100/50 to 100/5. When the mass ratio is 100/5 or less, the light transmittance in the range from 400 nm to 500 nm can be suppressed, thereby facilitating further improvement of color purity. In addition, when the mass ratio is 100/50 or more, the shift of the dominant wavelength toward the shorter wavelength side can be prevented, and the amount of deviation from the intended NTSC hue is further decreased. The mass ratio is particularly preferably from 100/30 to 100/10. In the case of where two or more red pigments are used in combination, the content ratio between them may be adjusted in accordance with the intended chromaticity.

Examples of the green pigment include a halogenated phthalocyanine pigment, which may be used alone or in combination with a disazo yellow pigment, a quinophthalone yellow pigment, an azomethine yellow pigment, or an isoindoline yellow pigment. Preferable examples of the combination include a combination of C. I. Pigment Green 7, 36, or 37 with C. I. Pigment Yellow 83, C.I. pigment Yellow 138, C. I. Pigment Yellow 139, C. I. Pigment Yellow 150, C. I. Pigment Yellow 180, or C. I. Pigment Yellow 185. The mass ratio of the green pigment to the yellow pigment in the combination is preferably from 100/150 to 100/5, particularly preferably from 100/120 to 100/30.

Examples of the blue pigment include a phthalocyanine pigment, which may be used alone or in combination with a dioxazine violet pigment. For example, a combination of C. I. Pigment Blue 15:6 and C. I. Pigment Violet 23 is preferred. The mass ratio of the blue pigment to the violet pigment in the combination is preferably from 100/30 to 100/1, and more preferably from 100/10 to 100/1.

In the case of where the colored photosensitive composition is used for forming a black matrix of a color filter, examples of the pigment used therein include carbon, titanium carbon, iron oxide, or titanium oxide, which may be used alone or in combination. Among them, the combination of carbon and titanium carbon is preferred. The mass ratio of carbon to titanium carbon in the combination is preferably from 100/60 to 100/1.

In the case of where the colored photosensitive composition is used for a color filter, the primary particle diameter of the pigment as a coloring agent is preferably 100 nm or less from the viewpoint of color unevenness and contrast, and preferably 5 nm or more from the viewpoint of dispersion stability. The primary particle diameter of the pigment is more preferably from 5 to 75 nm, even more preferably from 5 to 55 nm, and particularly preferably from 5 to 35 nm. The primary particle diameter of the pigment may be measured by a known method such as electron microscopy.

In particular, the pigment is preferably selected from an anthraquinone pigment, an azomethine pigment, a benzylidene pigment, a cyanine pigment, a diketopyrrolopyrrole pigment, and a phthalocyanine pigment.

### (Dye)

The coloring agent in the invention is preferably a dye from the viewpoint of forming a pattern with a higher definition. In particular, from the viewpoint of forming a fine rectangular pattern, it is preferable that a coloring agent be a dye soluble in an organic solvent, and more preferable that all of coloring agents be dyes soluble in an organic solvent. Examples of the dye include known dyes, for example, dyes disclosed in JP-A Nos. 64-90403, 64-91102, 1-94301, and 6-11614, Japanese Patent No. 2592207, U.S. Patent Nos. 4,808,501, 5,667,920, and 5,059,500, and JP-ANo. 6-35183. Examples of the chemical structure of the dye include triphenylmethane, anthraquinone, benzylidene, oxonol, cyanine, phenothiazine, pyrrolopyrazole azomethine, xanthene, phthalocyanine, benzopyran, and indigo pigments. Particularly preferred are pyrazoleazo, anilinoazo, pyrazolotriazoleazo, pyridoneazo, and anthrapyridone dyes. Other useful examples include a direct dye, a basic dye, a mordant dye, an acidic dye, an azoic dye, a dispersion dye, an oil-soluble dye, a food dye, and/or, derivatives thereof.

### (Acidic Dye)

Among the above dyes, the acidic dye is further described below. The acidic dye in the invention is not particularly limited as long as the acidic dye is a dye having an acidic group such as a sulfo group, a carboxyl group, or a phenolic hydroxyl group within the dye molecule. The acidic dye is selected in consideration of all functions required, such as solubility in an organic solvent or developing solution, salt forming properties with a basic compound, light absorbance, interaction with other components in the composition of the invention, light-fastness, and heat resistance.

Specific examples of the acidic dye include, but not limited to: Acid Alizarin Violet N; Acid Black 1, 2, 24, and 48; acid blue 1, 7, 9, 15, 18, 23, 25, 27, 29, 40, 42, 45, 51, 62, 70, 74, 80, 83, 86, 87, 90, 92, 96, 103, 112, 113, 120, 129, 138, 147, 150, 158, 171, 182, 192, 210, 242, 243, 256, 259, 267, 278, 280, 285, 290, 296, 315, 324:1, 335, and 340; Acid Chrome Violet K; acid Fuchsin; Acid Green 1, 3, 5, 9, 16, 25, 27, 50, 58, 63, 65, 80, 104, 105, 106, and 109; Acid Oorange 6, 7, 8, 10, 12, 26, 50, 51, 52, 56, 62, 63, 64, 74, 75, 94, 95107, 108, 169, and 173;
Acid Red 1, 4, 8, 14, 17, 18, 26, 27, 29, 31, 34, 35, 37, 42, 44, 50, 51, 52, 57, 66, 73, 80, 87, 88, 91, 92, 94, 97, 103, 111, 114, 129, 133, 134, 138, 143, 145, 150, 151, 158, 176, 182, 183, 198, 206, 211, 215, 216, 217, 227, 228, 249, 252, 257, 258, 260, 261, 266, 268, 270, 274, 277, 280, 281, 195, 308, 312, 315, 316, 339, 341, 345, 346, 349, 382, 383, 394, 401, 412, 417, 418, 422, and 426; Acid Violet 6B, 7, 9, 17, and 19; Acid Yellow 1,3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, and 251;
Direct Yellow 2, 33, 34, 35, 38, 39, 43, 47, 50, 54, 58, 68, 69, 70, 71, 86, 93, 94, 95, 98, 102, 108, 109, 129, 136, 138, and 141; Direct Orange 34, 39, 41, 46, 50, 52, 56, 57, 61, 64, 65, 68, 70, 96, 97, 106, and 107; Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, and 250; Direct Violet 47, 52, 54, 59, 60, 65, 66, 79, 80, 81, 82, 84, 89, 90, 93, 95, 96, 103, and 104;
Direct Blue 57, 77, 80, 81, 84, 85, 86, 90, 93, 94, 95, 97, 98, 99, 100, 101, 106, 107, 108, 109, 113, 114, 115, 117, 119, 137, 149, 150, 153, 155, 156, 158, 159, 160, 161, 162, 163, 164, 166, 167, 170, 171, 172, 173, 188, 189, 190, 192, 193, 194, 196, 198, 199, 200, 207, 209, 210, 212, 213, 214, 222, 228, 229, 237, 238, 242, 243, 244, 245, 247, 248, 250, 251, 252, 256, 257, 259, 260, 268, 274, 275, and 293;Direct Green 25, 27, 31, 32, 34, 37, 63, 65, 66, 67, 68, 69, 72, 77, 79, and 82; Mordant Yellow 5, 8, 10, 16, 20, 26, 30, 31, 33, 42, 43, 45, 56, 50, 61, 62, and 65; Mordant Orange 3, 4, 5, 8, 12, 13, 14, 20, 21, 23, 24, 28, 29, 32, 34, 35, 36, 37, 42, 43, 47, and 48;
Mordant Red 1, 2, 3, 4, 9, 11, 12, 14, 17, 18, 19, 22, 23, 24, 25, 26, 30, 32, 33, 36, 37, 38, 39, 41, 43, 45, 46, 48, 53, 56, 63, 71, 74, 85, 86, 88, 90, 94, and 95; Mordant Violet 2, 4, 5, 7, 14, 22, 24, 30, 31, 32, 37, 40, 41, 44, 45, 47, 48, 53, and 58; Mordant Blue 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, and 84; Mordant Green 1, 3, 4, 5, 10, 15, 19, 26, 29, 33, 34, 35, 41, 43, and 53; Food Yellow 3; and derivatives of these dyes.

Among these acidic dyes, preferred dyes are Acid Black 24; Acid Blue 23, 25, 29, 62, 80, 86, 87, 92, 138, 158, 182, 243, and 324:1; Acid Orange 8, 51, 56, 74, and 63; Acid Red 1, 4, 8, 34, 37, 42, 52, 57, 80, 97, 114, 143, 145, 151, 183, 217, and 249; Acid Violet 7; Acid Yellow 17, 25, 29, 34, 42, 72, 76, 99, 111, 112, 114, 116, 134, 155, 169, 172, 184, 220, 228, 230, 232, and 243; Acid Green 25; and derivatives of these dyes.

The derivative of the acidic dye may be an inorganic salt of an acidic dye having a sulfo group or a carboxyl group, a salt and/or an amide compound with a nitrogen-containing compound, and is not particularly limited as long as it is soluble in the composition of the invention. The acidic dye derivative is selected in consideration of all functions required, such as solubility in an organic solvent or developing solution, light absorbance, interaction with other components in the composition of the invention, light-fastnes, and heat resistance.

The salt and amide compound of an acidic dye with a nitrogen-containing compound are further described below. When an acidic dye forms a salt or amide compound with a nitrogen-containing compound, the acidic dye has an improved solubility (impart the solubility in an organic solvent) and improved heat resistance and light-fastness. The nitrogen-containing compound which forms a salt with an acidic dye, the nitrogen-containing compound which forms an amide bond with an acidic dye is selected in consideration of the solubility of the salt or amide compound in an organic solvent or developing solution, salt forming properties, light absorbance and chromatic valence of the dye, interaction with other components in the composition of the invention, and heat resistance and light-fastness as a coloring agent. From the viewpoint of absorbance and chromatic valence, the nitrogen-containing compound preferably has a smaller molecular weight, and the molecular weight is preferably 300 or less, more preferably 280 or less, and particularly preferably 250 or less.

The molar ratio (hereinafter referred to as "n") of the nitrogen-containing compound to the acidic dye in the salt thereof is described below. The "n" is a value that determines the molar ratio of an acidic dye molecule to a nitrogen-containing compound as a counter ion, and the value may be freely selected in accordance with the conditions of salt formation between the acidic dye and nitrogen-containing compound. Specifically, a value in the range of 0<n≤ 5 is frequently used in practical cases in accordance with the number of acidic functional groups in the acidic dye, and is selected in consideration of all functions required, such as solubility in an organic solvent or developing solution, salt forming properties, absorbance, interaction with other components in the composition of the invention, light-fastness, and heat resistance. From the viewpoint of absorbance, the value "n" is preferably in the range of 0 < n ≤ 4.5, more preferably in the range of 0<n≤4, and particularly preferably in the range of 0 < n ≤ 3.5.

The photosensitive composition of the invention is particularly preferably composed of a dye having two or more hydrogen bond donors as a coloring agent from the viewpoint of suppressing development residues. Specific examples of the dye include the dyes described in JP-A No. 2006-243040. The colored photosensitive composition of the invention particularly preferably contains at least one phthalocyanine dye soluble in an organic solvent as a coloring agent from the viewpoints of light-fastness and heat resistance. In the invention, a phthalocyanine dye soluble in an organic solvent can be favorably used without particular limitation. Examples of the phthalocyanine dye soluble in an organic solvent include the dyes described in JP-ANos. 5-333207, 6-51115, and 6-194828. Particularly preferable examples of the organic solvent-soluble phthalocyanine dye include the dye compound represented by formula (I).

### (Dye compound represented by formula (I))

The dye compound represented by formula (I) is further described below. The dye compound represented by formula (I) is an organic solvent-soluble phthalocyanine dye which has a favorable molar extinction coefficient ε and a favorable chromatic valence, and meets the requirement for high light-fastness and high heat resistance at the same time.

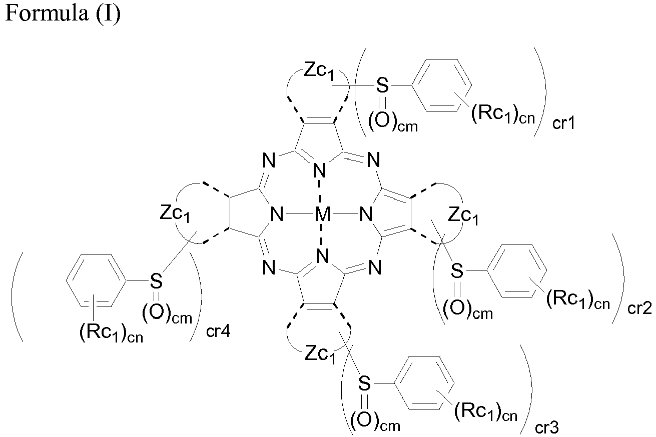

In formula (I), Rc₁ represents a halogen atom, an aliphatic group, an aryl group, a heterocyclic group, a cyano group, a carboxyl group, a carbamoyl group, an aliphatic oxycarbonyl group, an aryloxycarbonyl group, an acyl group, a hydroxyl group, an aliphaticoxy group, an aryloxy group, an acyloxy group, a carbamoyloxy group, a heterocyclic oxy group, an aliphatic oxycarbonyloxy group, an N-alkylacylamino group, a carbamoylamino group, a sulfamoylamino group, an aliphatic oxycarbonylamino group, an aryloxycarbonylamino group, an aliphatic sulfonylamino group, an arylsulfonylamino group, an aliphatic thio group, an arylthio group, an aliphatic sulfonyl group, an arylsulfonyl group, a sulfamoyl group, a sulfo group, an imide group, or a heterocyclic thio group. Zc₁ represents a group of nonmetal atoms necessary for forming a six-membered ring with carbon atoms, wherein four Zc₁s may be the same as or different from each other. M represents two hydrogen atoms, a divalent metal atom, a divalent metal oxide, a divalent metal hydroxide, or a divalent metal chloride. cm represents 0, 1, or 2, cn represents 0 or an integral number from 1 to 5, and four cns may be the same or different from each other. At least one cn represents an integral number from 1 to 5, and a plurality of Rc₁ in the molecule may be the same as or different from each other. cr1, cr2, cr3, and cr4 represent 0 or 1, and satisfies cr1 + cr2 + cr3 + cr4 ≥ 1.

In formula (I), "aliphatic group" may be linear, branched, or cyclic, and may be saturated or unsaturated. Examples thereof include an alkyl group, an alkenyl group, a cycloalkyl group, and a cycloalkenyl group which may be unsubstituted or substituted by a substituent. The "aryl group" may be a monocyclic or fused ring, and may be unsubstituted or substituted by a substituent. The "heterocyclic group" has a heteroatom (for example, nitrogen atom, sulfur atom, or oxygen atom) in the hetero ring, wherein the ring may be saturated or unsaturated, may be monocyclic or fused ring, and may be unsubstituted or substituted by a substituent.

In formula (I), the "substituent" refers to a group capable of substitution, and examples thereof include an aliphatic group, an aryl group, a heterocyclic group, an acyl group, an imide group, an azo group, an acyloxy group, an acylamino group, an aliphatic oxy group, an aryloxy group, a heterocyclic oxy group, an aliphatic oxycarbonyl group, an aryloxycarbonyl group, a heterocyclic oxy carbonyl group, a carbamoyl group, an aliphatic sulfonyl group, an arylsulfonyl group, a heterocyclic sulfonyl group, an aliphatic sulfonyloxy group, an arylsulfonyloxy group, a heterocyclic sulfonyloxy group, a sulfamoyl group, an aliphatic sulfonamide group, an arylsulfonamide group, a heterocyclic sulfonamide group, an amino group, an aliphatic amino group, an arylamino group, a heterocyclic amino group, an aliphatic oxycarbonylamino group, an aryloxycarbonylamino group, a heterocyclic oxycarbonylamino group, an aliphatic sulfinyl group, an arylsulfinyl group, an aliphatic thio group, an arylthio group, a heterocyclic thio group, a hydroxyl group, a cyano group, a sulfo group, a carboxyl group, an aliphatic oxyamino group, an aryloxyamino group, a carbamoylamino group, a sulfamoylamino group, a halogen atom, a sulfamoylcarbamoyl group, a carbamoylsulfamoyl group, a dialiphatic oxyphosphinyl group, and a diaryloxyphosphinyl group.

In formula (I), Rc₁ represents a halogen atom, an aliphatic group, an aryl group, a heterocyclic group, a cyano group, a carboxyl group, a carbamoyl group, an aliphatic oxycarbonyl group, an aryloxycarbonyl group, an acyl group, a hydroxyl group, an aliphatic oxy group, an aryloxy group, an acyloxy group, a carbamoyloxy group, a heterocyclic oxy group, an aliphatic oxycarbonyloxy group, an N-alkylacylamino group, a carbamoylamino group, a sulfamoylamino group, an aliphatic oxycarbonylamino group, an aryloxycarbonylamino group, an aliphatic sulfonylamino group, an arylsulfonylamino group, an aliphaticthio group, an arylthio group, an aliphatic sulfonyl group, an arylsulfonyl group, a sulfamoyl group, a sulfo group, an imide group, or a heterocyclic thio group.

Examples of the halogen atom represented by Rc include a fluorine atom, a chlorine atom, and a bromine atom.

The aliphatic group represented by Rc₁ may be unsubstituted or substituted by a substituent. The aliphatic group may be saturated or unsaturated, and may be cyclic. As the aliphatic group, an aliphatic group having 1 to 15 carbon atoms is preferred, and examples thereof include methyl group, ethyl group, vinyl group, allyl group, ethynyl group, isopropenyl group and 2-ethylhexyl group.

The aryl group represented by Rc₁ may be unsubstituted or substituted by a substituent. As the aryl group, an aryl group having 6 to 16 carbon atoms is preferred and an aryl group having 6 to 12 carbon atoms is more preferred. Examples thereof include phenyl group, 4-nitrophenyl group, 2-nitrophenyl group, 2-chlorophenyl group, 2,4-dichlorophenyl group, 2,4-dimethylphenyl group, 2-methylphenyl group, 4-methoxyphenyl group, 2-methoxyphenyl group and 2-methoxycarbonyl-4-nitrophenyl group.

The heterocyclic group represented by Rc₁ may be saturated or unsaturated. As the heterocyclic group, a heterocyclic group having 1 to 15 carbon atoms is preferred, and a heterocyclic group having 3 to 10 carbon atoms is more preferred. Examples thereof include 3-pyridyl group, 2-pyridyl group, 2-pyrimidinyl group, 2-pyrazinyl group and 1-piperidinyl group. Moreover, the heterocyclic group may further have a substituent.

The carbamoyl group represented by Rc₁ may be unsubstituted or substituted by a substituent. As the carbamoyl group, a carbamoyl group having 1 to 16 carbon atoms is preferred, and a carbamoyl group having 1 to 12 carbon atoms is more preferred. Examples thereof include carbamoyl group, dimethylcarbamoyl group and dimethoxyethylcarbamoyl group.

The aliphatic oxycarbonyl group represented by Rc₁ may be unsubstituted or substituted by a substituent. The aliphatic oxycarbonyl group may be saturated or unsaturated, and may be cyclic. As the aliphatic oxycarbonyl group, an aliphatic oxycarbonyl group having 2 to 16 carbon atoms is preferred, and an aliphatic oxycarbonyl group having 2 to 10 carbon atoms is more preferred. Examples thereof include methoxycarbonyl group and butoxycarbonyl group.

The aryloxycarbonyl group represented by Rc₁ may be unsubstituted or substituted by a substituent. As the aryloxycarbonyl group, an aryloxycarbonyl group having 7 to 17 carbon atoms is preferred, and an aryloxycarbonyl group having 7 to 15 carbon atoms is more preferred. Examples thereof include phenoxycarbonyl group.

The acyl group represented by Rc₁ may be an aliphatic carbonyl group or an arylcarbonyl group, wherein the aliphatic carbonyl group may be substituted by a substituent, and the arylcarbonyl group may be substituted by a substituent, and the acyl group may be saturated or unsaturated, and may be cyclic. The acyl group is preferably an acyl group having 2 to 15 carbon atoms, more preferably an acyl group having 2 to 10 carbon atoms. Examples thereof include an acetyl group, a pivaloyl group, and a benzoyl group. These groups may be substituted by a substituent.

The aliphatic oxy group represented by Rc₁ may be unsubstituted or substituted by a substituent. The aliphatic oxy group may be saturated or unsaturated, and may be cyclic. As the aliphatic oxy group, an aliphatic oxy group having 1 to 12 carbon atoms is preferred, and an aliphatic oxy group having 1 to 10 carbon atoms is more preferred. Examples thereof include methoxy group, ethoxyethoxy group, phenoxyethoxy group and thiophenoxyethoxy group.

The aryloxy group represented by Rc₁ may be unsubstituted or substituted by a substituent. As the aryloxy group, an aryloxy group having 6 to 18 carbon atoms is preferred, and an aryloxy group having 6 to 14 carbon atoms is more preferred. Examples thereof include phenoxy group and 4-methylpheoxy group.

The acyloxy group represented by Rc₁ may be unsubstituted or substituted by a substituent. As the acyloxy group, an acyloxy group having 2 to 14 carbon atoms is preferred, and an acyloxy group having 2 to 10 carbon atoms is more preferred. Examples thereof include acetoxy group, methoxyacetoxy group and benzoyloxy group.

The carbamoyloxy group represented by Rc₁ may be unsubstituted or substituted by a substituent. As the carbamoyloxy group, a carbamoyloxy group having 1 to 16 carbon atoms is preferred, and a carbamoyloxy group having 1 to 12 carbon atoms is more preferred. Examples thereof include dimethylcarbamoyloxy group and diisopropylcarbamoyloxy group.

The heterocyclic oxy group represented by Rc₁ may be unsubstituted or substituted by a substituent. As the heterocyclic oxy group, a heterocyclic oxy group having 1 to 15 carbon atoms is preferred, and a heterocyclic oxy group having 3 to 10 carbon atoms is more preferred. Examples thereof include 3-furyloxy group, 3-pyridyloxy group and N-methyl-2-piperidyloxy group.

The aliphatic oxycarbonyloxy group represented by Rc₁ may be unsubstituted or substituted by a substituent. The aliphatic oxycarbonyloxy group may be saturated or unsaturated, and may be cyclic. As the aliphatic oxycarbonyloxy group, an aliphatic oxycarbonyloxy group having 2 to 16 carbon atoms is preferred, and an aliphatic oxycarbonyloxy group having 2 to 10 carbon atoms is more preferred. Examples thereof include methoxycarbonyloxy group and (t)-butoxycarbonyloxy group.

The N-alkylacylamino group represented by Rc₁ may be unsubstituted or substituted by a substituent. As the N-alkylacylamino group, an N-alkylacylamino group having 3 to 15 carbon atoms is preferred, and an N-alkylacylamino group having 3 to 12 carbon atoms is more preferred. Examples thereof include N-methylacetylamino group, N-ethoxyethylbenzoylamino group and N-methylmethoxyacetylamino group.

The carbamoylamino group represented by Rc₁ may be unsubstituted or substituted by a substituent. As the carbamoylamino group, a carbamoylamino group having 1 to 16 carbon atoms is preferred, and a carbamoylamino group having 1 to 12 carbon atoms is more preferred. Examples thereof include N,N-dimethylcarbamoylamino group and N-methyl-N-methoxyethylcarbamoylamino group.

The sulfamoylamino group represented by Rc₁ may be unsubstituted or substituted by a substituent. As the sulfamoylamino group, a sulfamoylamino group having 0 to 16 carbon atoms is preferred, and a sulfamoylamino group having 0 to 12 carbon atoms is more preferred. Examples thereof include N,N-dimethylsulfamoylamino group and N,N-diehtylsulfamoyl group.

The aliphatic oxycarbonylamino group represented by Rc₁ may be unsubstituted or substituted by a substituent. As the aliphatic oxycarbonylamino group, an aliphatic oxycarbonylamino group having 2 to 15 carbon atoms is preferred, and an aliphatic oxycarbonylamino group having 2 to 10 carbon atoms is more preferred. Examples thereof include methoxycarbonylamino group and methoxyethoxycarbonylamino group.

The aryloxycarbonylamino group represented by Rc₁ may be unsubstituted or substituted by a substituent. As the aryloxycarbonylamino group, an aryloxycarbonylamino group having 7 to 17 carbon atoms is preferred, and an aryloxycarbonylamino group having 7 to 15 carbon atoms is more preferred. Examples thereof include a phenoxycarbonylamino group and a 4-methoxyphenoxycarbonylamino group.

The aliphatic sulfonylamino group represented by Rc₁ may be unsubstituted or substituted by a substituent. The aliphatic sulfonylamino group may be saturated or unsaturated, and may be cyclic. As the aliphatic sulfonylamino group, an aliphatic sulfonylamino group having 1 to 12 carbon atoms is preferred, and an aliphatic sulfonylamino group having 1 to 8 carbon atoms is more preferred. Examples thereof include methanesulfonylamino group and butanesulfonylamino group.

The arylsulfonylamino group represented by Rc₁ may be unsubstituted or substituted by a substituent. As the arylsulfonylamino group, an arylsulfonylamino group having 6 to 15 carbon atoms is preferred, and an arylsulfonylamino group having 6 to 12 carbon atoms is more preferred. Examples thereof include benzenesulfonylamino group and 4-toluenesulfonylamino group.

The aliphatic thio group represented by Rc₁ may be unsubstituted or substituted by a substituent. The aliphatic thio group may be saturated or unsaturated, and may be cyclic. As the aliphatic thio group, an aliphatic thio group having 1 to 16 carbon atoms is preferred, and an aliphatic thio group having 1 to 10 carbon atoms is more preferred. Examples thereof include methylthio group, ethylthio group and ethoxyehtylthio group.

The aliphatic sulfonyl group represented by Rc₁ may be unsubstituted or substituted by a substituent. As the aliphatic sulfonyl group, an aliphatic sulfonyl group having 1 to 15 carbon atoms is preferred, and an aliphatic sulfonyl group having 1 to 8 carbon atoms is more preferred. Examples thereof include a methanesulfonyl group, a butanesulfonyl group, and a methoxyethanesulfonyl group. The arylsulfonyl group represented by Rc₁ may be unsubstituted or substituted by a substituent. As the arylsulfonyl group, an arylsulfonyl group having 6 to 16 carbon atoms is preferred, and an arylsulfonyl group having 6 to 12 carbon atoms is more preferred. Examples thereof include a benzenesulfonyl group, a 4-t-butylbenzenesulfonyl group, a 4-toluenesulfonyl group, and a 2-toluenesulfonyl group.

The sulfamoyl group represented by Rc₁ may be unsubstituted or substituted by a substituent. As the sulfamoyl group, a sulfamoyl group having 0 to 16 carbon atoms is preferred, and a sulfamoyl group having 0 to 12 carbon atoms is more preferred. Examples thereof include sulfamoyl group and dimethylsulfamoyl group.

The imido group represented by Rc₁ may be further condensed. As the imido group, an imido group having 3 to 22 carbon atoms is preferred, and an imido group having 3 to 15 carbon atoms is more preferred. Examples thereof include succinimido group and phthalimido group.

The heterocyclic thio group represented by Rc₁ may be unsubstituted or substituted by a substituent. As the heterocyclic thio group, a 5 to 7-membered heterocyclic thio group having 1 to 20 carbon atoms is preferred, and a 5 to 7-membered heterocyclic thio group having 1 to 12 carbon atoms is more preferred. Examples thereof include 3-furylthio group and 3-pyridylthio group.

In formula (I), Zc₁ represents a group of nonmetal atoms necessary for forming a six-membered ring together with carbon atoms, wherein four Zc₁s may be the same as or different from each other. The six-membered rings to be formed may be aryl rings or heterocycles, wherein the rings may be fused, and the fused rings may be substituted by a substituent. The six-membered ring may be, for example, a benzene ring, a pyridine ring, a cyclohexene ring, or a naphthalene ring, and is preferably a benzene ring.

In formula (I), M represents two hydrogen atoms, a divalent metal atom, a divalent metal oxide, a divalent metal hydroxide, or a divalent metal chloride. The M may be, for example, VO, TiO, Zn, Mg, Si, Sn, Rh, Pt, Pd, Mo, Mn, Pb, Cu, Ni, Co, Fe, AlCl, InCl, FeCl, TiCl₂, SnCl₂, SiCl₂, GeCl₂, Si(OH)₂, or H₂, and is preferably VO, Zn, Mn, Cu, Ni, or Co.

In formula (I), cm represents 0, 1, or 2 (preferably 0), and cn represents 0 or an integral number from 1 to 5 (preferably 0 or 1). The four cns in the molecule may be the same as or different from each other, wherein one of the cn represents an integral number from 1 to 5, In the case of where a plurality of cns are contained in one molecule, a plurality of Rc₁s may be the same as or different from each other. cr1, cr2, cr3, and cr4 represent 0 or 1, and satisfy cr1 + cr2 + cr3 + cr4 ≥ 1. In particular, the sum of cr1, cr2, cr3, and cr4 is preferably 3 or 4.

Among the dye compounds represented by formula (I), the dye represented by formula (I-1) is preferred.

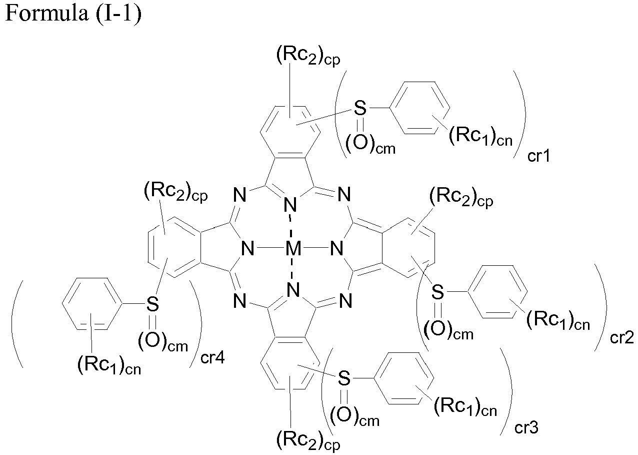

In formula (I-1), Rc₂ represents a substituent, the substituent may be a group capable of substitution, and examples thereof include groups listed in the above-described section "Substituent". The substituent is preferably an aliphatic group, an aryl group, a heterocyclic group, an N-alkylacylamino group, an aliphatic oxy group, an aryloxy group, a heterocyclic oxy group, an aliphatic oxycarbonyl group, an aryloxycarbonyl group, a heterocyclic oxycarbonyl group, a carbamoyl group, an aliphatic sulfonyl group, a sulfamoyl group, an aliphatic sulfonamide group, an arylsulfonamide group, an aliphatic amino group, an arylamino group, an aliphatic oxycarbonylamino group, an aryloxycarbonylamino group, an aliphatic thio group, an arylthio group, a hydroxyl group, a cyano group, a sulfo group, a carboxyl group, a carbamoylamino group, a sulfamoylamino group, or a halogen atom, and more preferably an aliphatic group, an N-alkylacylamino group, an aliphatic oxy group, an aliphatic oxycarbonyl group, an aliphatic sulfonyl group, an aliphatic thio group, an arylthio group, a sulfo group, a carboxyl group, or a halogen atom.

In formula (I-1), cp represents an integral number from 0 to 4, and is preferably 0 or 1. All of cp + cr1, cp + cr2, cp + cr3, and cp + cr4 represent an integral number from 0 to 4. When a plurality of Rc₂s are present in one molecule, the plurality of Rc₂s may be the same as or different from each other. Rc₁, M, cm, cn, cr1, cr2, cr3, and cr4 in formula (I-1) are the same meaning as those in formula (I), and preferable exemplary embodiments are also the same.

Among the dye compounds represented by formula (I-1), the dye represented by formula (I-2) is more preferred.

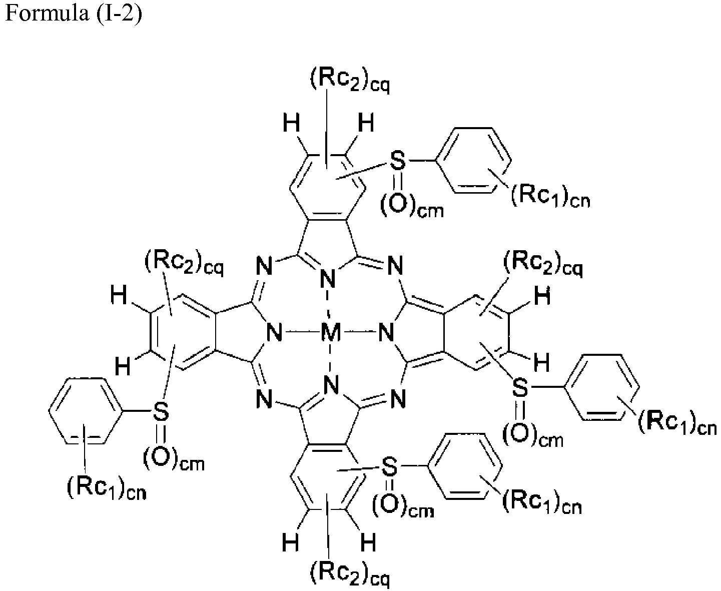

In formula (I-2), Rc₁, Rc₂, M, cm, and cn are the same meaning as those in formulae (I) and (I-1), and preferable exemplary embodiments are also the same. cq in formula (I-2) represents 0 or 1. The phthalocyanine skeleton has a structure wherein four benzene rings are fused on the outside of a tetraazaporphyrin skeleton, and each benzene ring has four substitutable sites (carbon atoms). In formula (I-2), hydrogen atoms combine with two site (β sites) placed far from the tetraazaporphyrin skeleton of each benzene ring.

In formula (I-2), from the viewpoint of exhibiting the effect of the invention more effectively, an embodiment wherein Rc₁ is a halogen atom, aliphatic group, cyano group, carbamoyl group, aliphatic oxycarbonyl group, aryloxycarbonyl group, hydroxyl group, aliphatic oxy group, carbamoyloxy group, heterocyclic oxy group, aliphatic oxycarbonyloxy group, carbamoylamino group, sulfamoylamino group, aliphatic oxycarbonylamino group, aliphatic sulfonylamino group, arylsulfonylamino group, aliphatic thio group, arylthio group, aliphatic sulfonyl group, arylsulfonyl group, sulfamoyl group, imido group or sulfo group, is preferred, an embodiment wherein Rc₁ is aliphatic group, carbamoyl group, aliphatic oxycarbonyl group, aryloxycarbonyl group, aliphatic oxy group, aliphatic oxycarbonyloxy group, carbamoylamino group, sulfamoylamino group, aliphatic oxycarbonylamino group, aliphatic sulfonylamino group, arylsulfonylamino group, aliphatic sulfonyl group, arylsulfonyl group, sulfamoyl group, imido group or sulfo group, is more preferred, and an embodiment wherein Rc₁ is a carbamoyl group, aliphatic oxycarbonyl group, aliphatic oxy group, aliphatic oxycarbonyloxy group, carbamoylamino group, aliphatic oxycarbonylamino group, arylsulfonyl group, imido group or aliphatic sulfonyl group, is the most preferred.

Similarly, from the viewpoint of exerting the effect of the invention more effectively, Rc₂ is preferably an aliphatic group, an N-alkylacylamino group, an aliphatic oxy group, an aliphatic oxycarbonyl group, an aliphatic sulfonyl group, an aliphatic thio group, an arylthio group, a sulfo group, a carboxyl group, or a halogen atom, and more preferably an aliphatic group or a halogen atom. Similarly, from the viewpoint of exhibiting the effect of the invention more effectively, cq is preferably 0. Similarly, from the viewpoint of exhibiting the effect of the invention more effectively, M is preferably VO, Mn, Co, Ni, Cu, Zn, or Mg, more preferably VO, Co, Cu, or Zn, and most preferably Cu. cm is preferably 0; and cn is preferably 1 or 2, and more preferably 1.

From the viewpoint of exhibiting the effect of the invention even more effectively, in formula (II-2), an embodiment wherein the Rc₁ is a halogen atom, aliphatic group, cyano group, carbamoyl group, aliphatic oxycarbonyl group, aryloxycarbonyl group, hydroxyl group, aliphatic oxy group, carbamoyloxy group, heterocyclic oxy group, aliphatic oxy carbonyloxy group, carbamoylamino group, sulfamoylamino group, aliphatic oxycarbonylamino group, aliphatic sulfonylamino group, arylsulfonylamino group, aliphatic-thio group, arylthio group, aliphatic sulfonyl group, arylsulfonyl group, sulfamoyl group, imido group or sulfo group; M is VO, Co, Cu or Zn; cq is 0; cm is 0; and cn is 1, is preferred. Moreover, an embodiment wherein Rc₁ is an aliphatic group, carbamoyl group, aliphatic oxycarbonyl group, aryloxycarbonyl group, aliphatic oxy group, aliphatic oxycarbonyloxy group, carbamoylamino group, sulfamoylamino group, aliphatic oxycarbonylamino group, aliphatic sulfonylamino group, arylsulfonylamino group, aliphatic sulfonyl group, arylsulfonyl group, sulfamoyl group, imido group or sulfo group; M is VO, Co, Cu or Zn; cq is 0; cm is 0; and cn is 1, is more preferred.

Similarly, the viewpoint of exhibiting the effect of the invention even more effectively, an embodiment wherein Rc₁ is a carbamoyl group, aliphatic oxycarbonyl group, aliphatic oxy group, carbamoylamino group, aliphatic oxycarbonylamino group, aliphatic sulfonyl group, arylsulfonyl group or imido group; M is Cu; cq is 0; cm is 0; and cn is 1, is the most preferred.

Specific examples of the dyes represented by formulae (I), (I-1), and (I-2) (exemplary compounds C-1 to C-59) are listed below. However, the invention is not limited to them.

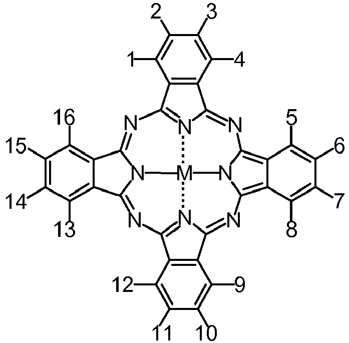

| Exemplary compound | M | Substituents at 1 or 4, 5 or 8, 9 or 12, and 13 or 16 (other four sites are unsubstituted) | Substituents at the other eight sites |
|---|---|---|---|
| C-1 | Cu | 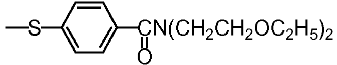 | H |
| C-2 | Cu | 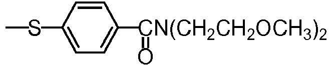 | H |
| C-3 | Cu | 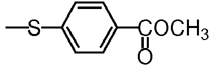 | H |
| C-4 | Cu | 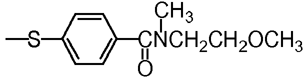 | H |
| C-5 | Cu | 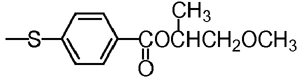 | H |
| C-6 | Cu | 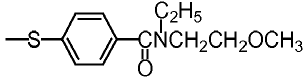 | H |
| C-7 | Cu | 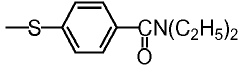 | H |
| C-8 | Cu | 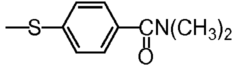 | H |

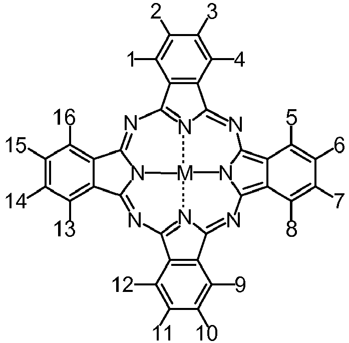

| Exemplary compound | M | Substituents at 1 or 4, 5 or 8, 9 or 12, and 13 or 16 (other four sites are unsubstituted) | Substituents at the other eight sites |
|---|---|---|---|
| C-9 | Cu | 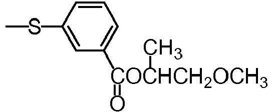 | H |
| C-10 | Cu | 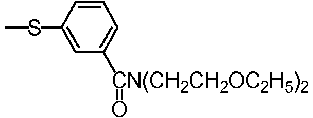 | H |
| C-11 | Cu | 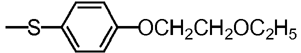 | H |
| C-12 | Cu | 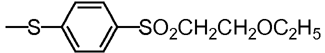 | 2 or 3, 6 or 7, 10 or 11, and 14 or 15 are substituted with CH₃, respectively, and other four sites are unsubstituted. |
| C-13 | Cu | 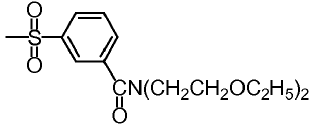 | H |
| C-14 | Cu | 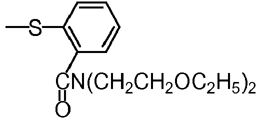 | H |
| C-15 | Cu | 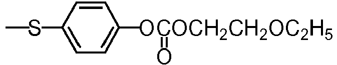 | 2 or 3, 6 or 7, 10 or 11, and 14 or 15 are substituted with CH₃, respectively, and other four sites are unsubstituted. |

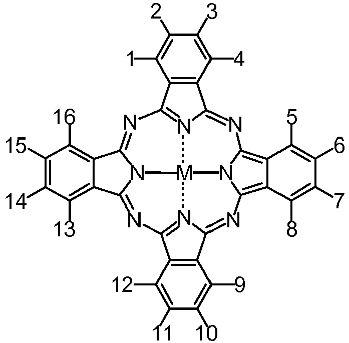

| Exemplary compound | M | Substituents at 1 or 4, 5 or 8, 9 or 12, and 13 or 16 (other four sites are unsubstituted) | Substituents at the other eight sites |
|---|---|---|---|
| C-16 | Cu | 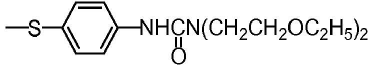 | H |
| C-17 | Cu | 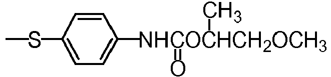 | H |
| C-18 | Cu | 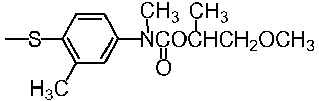 | H |
| C-19 | Cu | 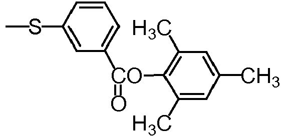 | H |
| C-20 | Cu | 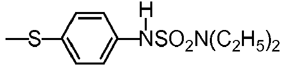 | H |
| C-21 | Cu | 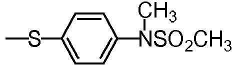 | H |
| C-22 | Cu | 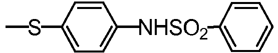 | H |

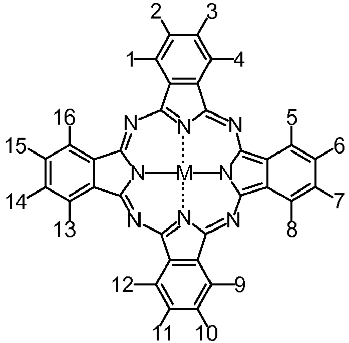

| Exemplary compound | M | Substituents at 1 or 4, 5 or 8, 9 or 12, and 13 or 16 (other four sites are unsubstituted) | Substituents at the other eight sites |
|---|---|---|---|
| C-23 | Cu | 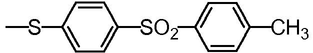 | H |
| C-24 | Cu | 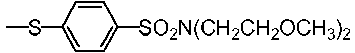 | H |
| C-25 | Cu | 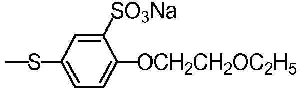 | H |
| C-26 | V=0 | 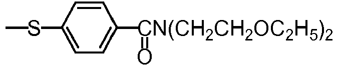 | H |
| C-27 | Co | 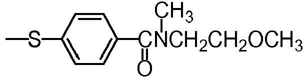 | H |
| C-28 | Co | 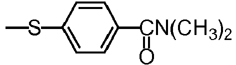 | H |
| C-29 | Zn | 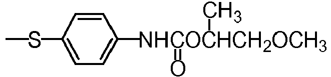 | H |
| C-30 | V=0 | 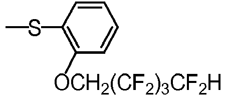 | H |

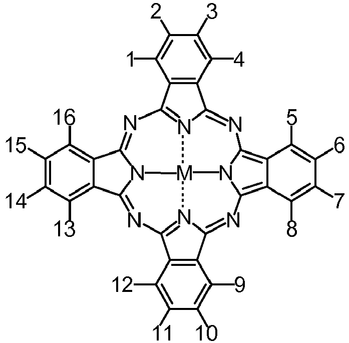

| Exemplary compound | M | Substituents at 1 or 4, 5 or 8, 9 or 12, and 13 or 16 (other four sites are unsubstituted) | Substituents at the other eight sites |
|---|---|---|---|
| C-31 | Cu | 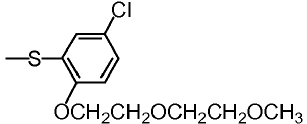 | H |
| C-32 | Cu | 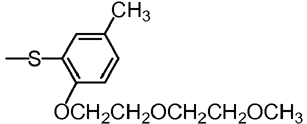 | H |
| C-33 | Cu | 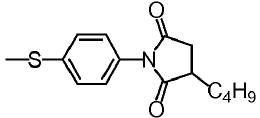 | H |
| C-34 | Cu | 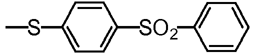 | H |
| C-35 | Cu | 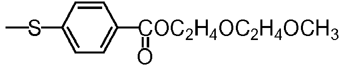 | H |

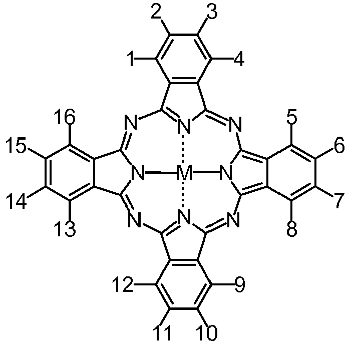

| Exemplary compound | M | Substituents at 2 or 3, 6 or 7, 10 or 11, and 14 or 15 (other four sites are unsubstituted) | Substituents at the other eight sites |
|---|---|---|---|
| C-41 | Cu | 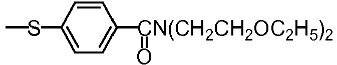 | H |
| C-42 | Cu | 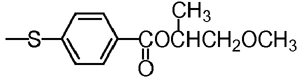 | H |
| C-43 | Cu | 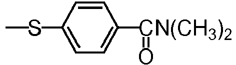 | H |
| C-44 | Cu | 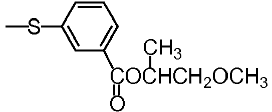 | H |
| C-45 | Co | 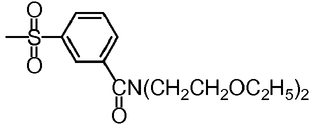 | H |

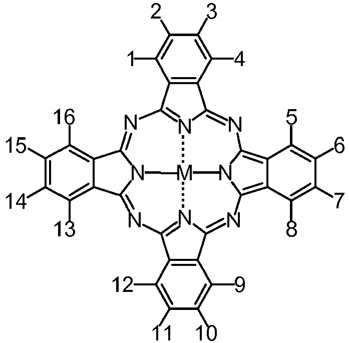

| Exemplary compound | M | Substituents at 2 or 3, 6 or 7, 10 or 11, and 14 or 15 (other four sites are unsubstituted) | Substituents at the other eight sites |
|---|---|---|---|
| C-46 | Zn | 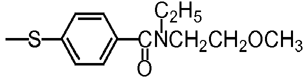 | H |
| C-47 | V=0 | 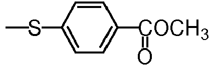 | H |
| C-48 | Cu | 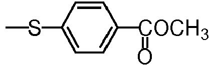 | 1 or 4, 5 or 8, 9 or 12, and 13 or 16 are substituted by CH₃, respectively, and other four sites are unsubstituted. |
| C-49 | Cu | 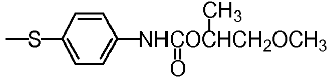 | H |

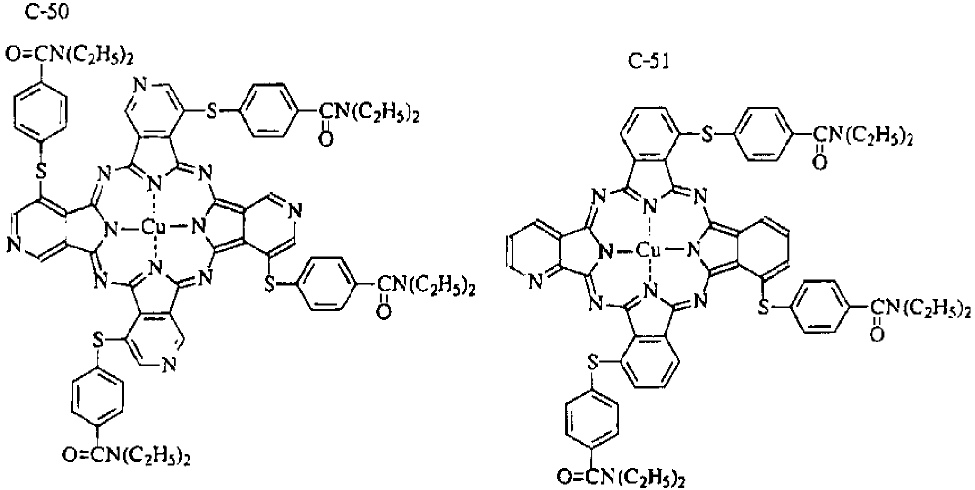

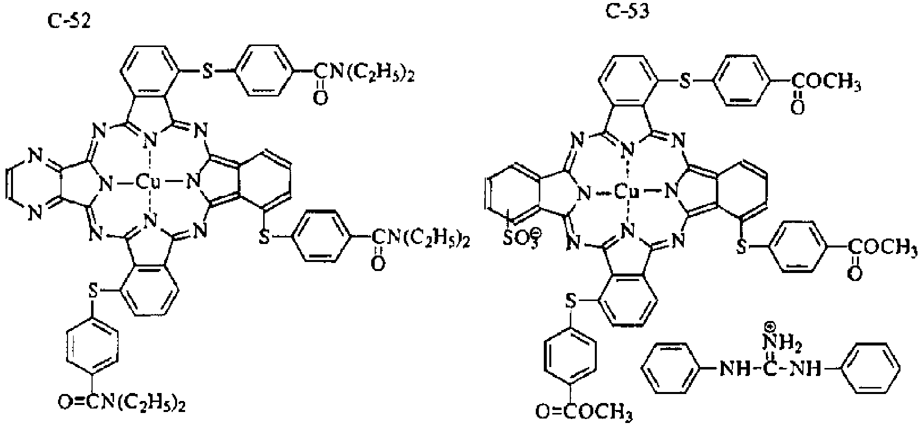

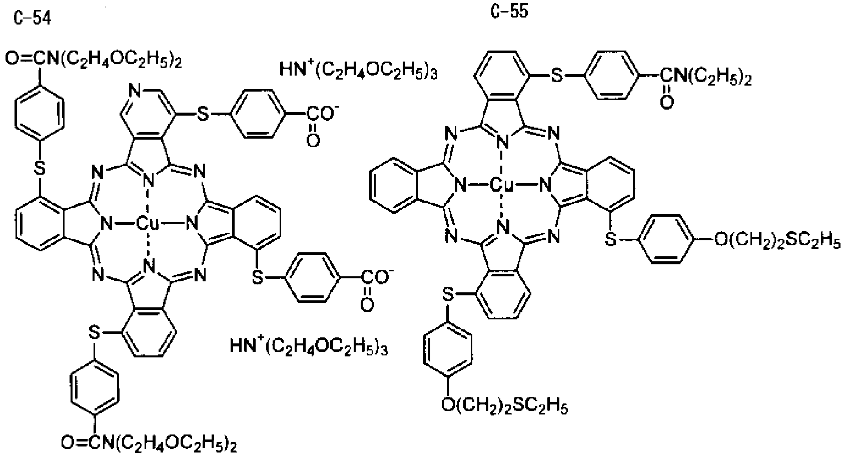

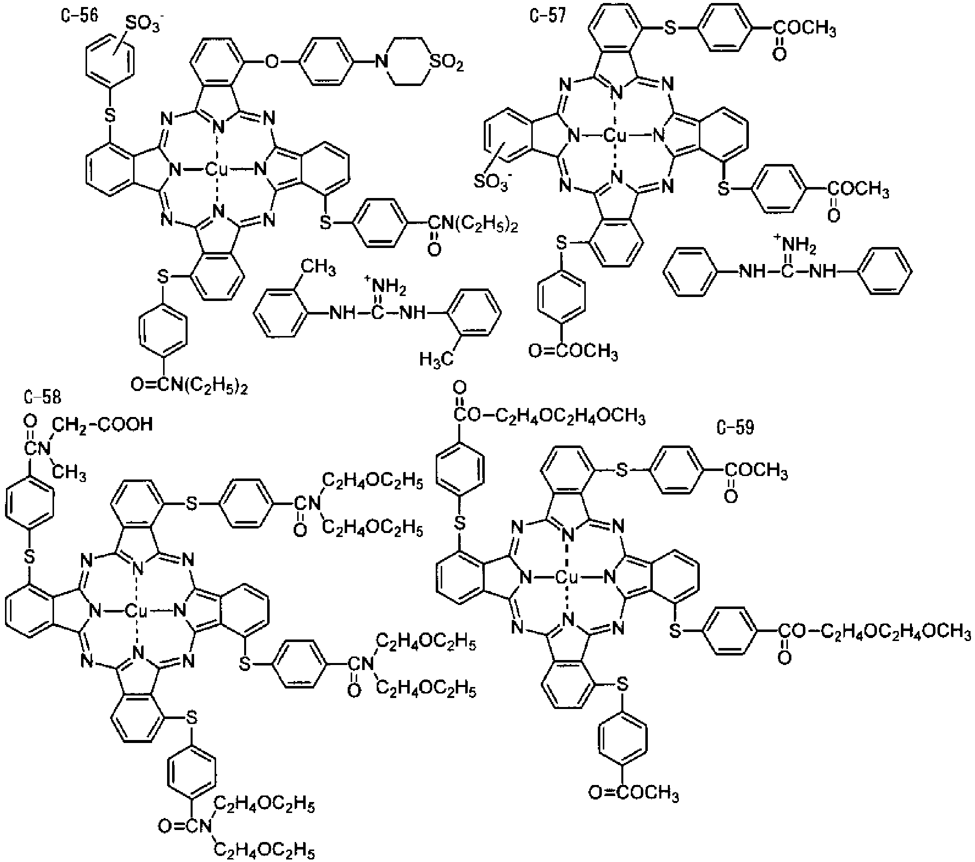

The content of the coloring agent in the colored photosensitive composition of the invention with reference to the total solid content is about 50% by mass to about 80% by mass, preferably from about 52 to about 75% by mass, and particularly preferably from about 55 to about 70% by mass from the viewpoint of absorbance attributable to the coloring agent and

### (B) Resin

Next, the resin is described below. As the colored photosensitive composition of the invention contains a resin having an acid value of 1 mg KOH/g to 70 mg KOH/g, peeling of patterns in low exposure amount areas can be prevented during development. The resin used in the invention (hereinafter may be referred to as binder) selected in consideration of heat resistance, developability, and availability.

The resin in the invention is a polymer compound having at least one unsaturated double bond selected from the structural units represented by formulae (1) to (3).

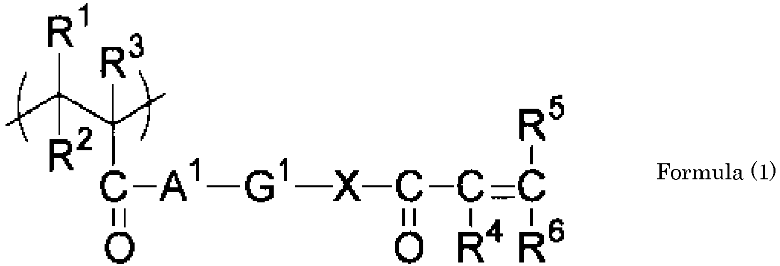

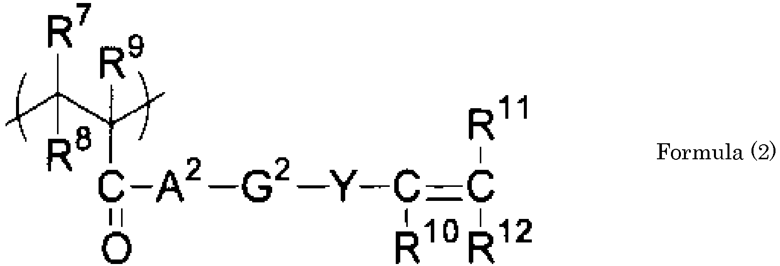

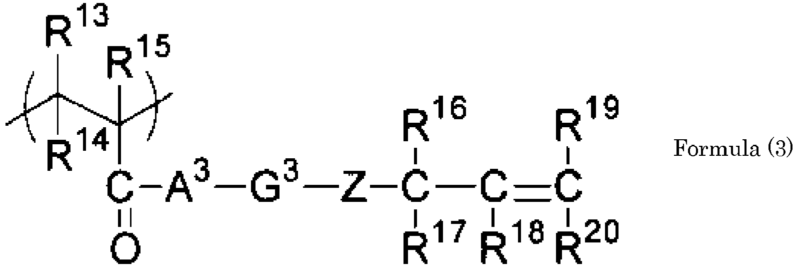

In formulae (1) to (3), A¹, A², and A³ each independently represent an oxygen atom, a sulfur atom, or -N(R²¹)-, wherein R²¹ represents an optionally substituted alkyl group. G¹, G², and G³ each independently represent a divalent organic group. X and Z each independently represent an oxygen atom, a sulfur atom, or -N(R²²)-, wherein R²² represents an optionally substituted alkyl group. Y represents an oxygen atom, a sulfur atom, an optionally substituted phenylene group, or -N(R²³)-, wherein R²³ represents an optionally substituted alkyl group. R¹ to R²⁰ each independently represent a monovalent substituent.

In formula (1), R¹ to R³ each independently represent a monovalent substituent such as a hydrogen atom or an optionally substituted alkyl group. In particular, R¹ and R² are preferably hydrogen atoms, and R³ is preferably a hydrogen atom or a methyl group. R⁴ to R⁶ each independently represent a monovalent substituent, wherein R⁴ may be a hydrogen atom or an optionally substituted alkyl group. Among them, a hydrogen atom, a methyl group, and an ethyl group are preferred. R⁵ and R⁶ each independently represent, for example, a hydrogen atom, a halogen atom, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylsulfonyl group, or an optionally substituted arylsulfonyl group. Among them, a hydrogen atom, an alkoxycarbonyl group, an optionally substituted alkyl group, and an optionally substituted aryl group are preferred. Examples of the substituent include a methoxycarbonyl group, an ethoxycarbonyl group, an isopropyloxycarbonyl group, a methyl group, an ethyl group, and a phenyl group.

A¹ represents an oxygen atom, a sulfur atom, or -N(R²¹)-, and X represents an oxygen atom, a sulfur atom, or -N(R²²)-, wherein R²¹ and R²² may be an optionally substituted alkyl group. G¹ represent a divalent organic group, and is preferably an optionally substituted alkylene group, and more preferably an optionally substituted alkylene group having 1 to 20 carbon atoms, an optionally substituted cycloalkylene group having 3 to 20 carbon atoms, or an optionally substituted aromatic group having 6 to 20 carbon atoms. Among them, an optionally substituted linear or branched alkylene group having 1 to 10 carbon atoms, an optionally substituted cycloalkylene group having 3 to 10 carbon atoms, an optionally substituted aromatic group having 6 to 12 carbon atoms are preferred from the viewpoint of performance such as strength and developability.

Preferable examples of the substituent in G¹ include a hydroxyl group, and substituents excluding the substituents having a hetero atom to which a hydrogen atom other than a hydrogen atom in a hydroxyl group is bonded (for example, an amino group, a thiol group, and a carboxyl group).

In the structural unit represented by formula (1) in the invention, A¹ is preferably an oxygen atom, a sulfur atom, or -N(R²¹)-, X is preferably an oxygen atom, a sulfur atom, or -N(R²²)-, G¹ is preferably an optionally substituted alkylene group, R¹ and R² are preferably hydrogen atoms, R³ is preferably a hydrogen atom or a methyl group, R⁴ is preferably a hydrogen atom or an alkyl group, R⁵, and R⁶ are each independently preferably a hydrogen atom, an alkoxycarbonyl group, an alkyl group, or an aryl group, and R²¹ and R²² are preferably alkyl groups.

In formula (2), R⁷ to R⁹ each independently represent a monovalent substituent such as a hydrogen atom or an optionally substituted alkyl group. In particular, R⁷ and R⁸ are preferably hydrogen atoms, and R⁹ is preferably a hydrogen atom or a methyl group. R¹⁰ to R¹² each independently represent a monovalent substituent. Specific examples of the substituent include a hydrogen atom, a halogen atom, a dialkylamino group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylsulfonyl group, and an optionally substituted arylsulfonyl group. Among them, a hydrogen atom, an alkoxycarbonyl group, an optionally substituted alkyl group, and an optionally substituted aryl group are preferred. Examples of the substituent include those listed for formula (1).

A² represents an oxygen atom, a sulfur atom, or -N(R²¹)-, wherein, R²¹ may be, for example, a hydrogen atom or an optionally substituted alkyl group. G² represents a divalent organic group, and is preferably an optionally substituted alkylene group. Preferable examples thereof include an optionally substituted alkylene group having 1 to 20 carbon atoms, an optionally substituted cycloalkylene group having 3 to 20 carbon atoms, and an optionally substituted aromatic group having 6 to 20 carbon atoms. Among them, an optionally substituted linear or branched alkylene group having 1 to 10 carbon atoms, an optionally substituted cycloalkylene group having 3 to 10 carbon atoms, and an optionally substituted aromatic group having 6 to 12 carbon atoms are preferred from the viewpoint of performance such as strength and developability. Examples of the substituent in G² include a hydroxyl group, and substituents excluding the substituents having a hetero atom to which a hydrogen atom other than a hydrogen atom in a hydroxyl group is bonded (for example, an amino group, a thiol group, and a carboxyl group). If G² has a substituent having a hetero atom to which a hydrogen atom other than a hydrogen atom in a hydroxyl group is bonded, storage stability may deteriorate by the combined use of an onium salt compound as the below-described initiator. Y represents an oxygen atom, a sulfur atom, -N(R²³)- or an optionally substituted phenylene group, wherein R²³ may be, for example, a hydrogen atom or an optionally substituted alkyl group.

In the structural unit represented by formula (2) in the invention, R¹⁰ is preferably a hydrogen atom or an alkyl group, R¹¹ and R¹² are each independently preferably a hydrogen atom, an alkoxycarbonyl group, an alkyl group, or an aryl group, R⁷ and R⁸ are preferably hydrogen atoms, R⁹ is preferably a hydrogen atom or a methyl group, A² is an oxygen atom, a sulfur atom, or -N(R²¹)-, G² is preferably an optionally substituted linear or branched alkylene group having 1 to 10 carbon atoms, an optionally substituted cycloalkylene group having 3 to 10 carbon atoms, or an optionally substituted aromatic group having 6 to 12 carbon atoms, Y is preferably an oxygen atom, a sulfur atom, -N(R²³)-, or an optionally substituted phenylene group, and R²¹ and R²³ are preferably hydrogen atoms or optionally substituted alkyl groups. In formula (3), R¹³ to R¹⁵ each independently represent a monovalent substituent such as a hydrogen atom or an optionally substituted alkyl group. In particular, R¹³ and R¹⁴ are preferably hydrogen atoms, R¹⁵ is preferably a hydrogen atom or a methyl group. R¹⁶ to R²⁰ each independently represent a monovalent substituent, wherein R¹⁶ to R²⁰ may be, for example, a hydrogen atom, a halogen atom, a dialkylamino group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylsulfonyl group, or an optionally substituted arylsulfonyl group. Among them, a hydrogen atom, an alkoxycarbonyl group, an optionally substituted alkyl group, and an optionally substituted aryl group are preferred. Examples of the substituent include those listed for formula (1). A³ represents an oxygen atom, a sulfur atom, or -N(R²¹)-, and Z represents an oxygen atom, a sulfur atom, or -N(R²²)-. Examples of R²¹ and R²² include those listed for formula (1).

G³ represent a divalent organic group, and is preferably an optionally substituted alkylene group. Preferable examples thereof include an optionally substituted alkylene group having 1 to 20 carbon atoms, an optionally substituted cycloalkylene group having 3 to 20 carbon atoms, and an optionally substituted aromatic group having 6 to 20 carbon atoms. Among them, an optionally substituted linear or branched alkylene group having 1 to 10 carbon atoms, an optionally substituted cycloalkylene group having 3 to 10 carbon atoms, and an optionally substituted aromatic group having 6 to 12 carbon atoms are preferred from the viewpoint of from the viewpoint of performance such as strength and developability. Preferable examples of the substituent in G³ include a hydroxyl group, and substituents excluding the substituents having a hetero atom to which a hydrogen atom other than a hydrogen atom in a hydroxyl group is bonded (for example, an amino group, a thiol group, and a carboxyl group).

In the structural unit represented by formula (3) in the invention, R¹³ and R¹⁴ are preferably hydrogen atoms, R¹⁵ is preferably a hydrogen atom or a methyl group, R¹⁶ to R²⁰ are preferably hydrogen atoms, alkoxycarbonyl groups, optionally substituted alkyl groups, or optionally substituted aryl groups, A³ is preferably an oxygen atom, a sulfur atom, or -N(R²¹)-, Z is preferably an oxygen atom, a sulfur atom, or -N(R²²)-, R²¹ and R²² are the same as those in formula (1), G³ is preferably an optionally substituted linear or branched alkylene group having 1 to 10 carbon atoms, an optionally substituted cycloalkylene group having 3 to 10 carbon atoms, or an optionally substituted aromatic group having 6 to 12 carbon atoms.

From the viewpoints of improving curability and reducing development residues, the resin in the invention is preferably a compound containing at least one structural unit selected from those represented by formula (1) to (3) at a ratio of 20 mol% or more and less than 95 mol%, more preferably from 25 to 90 mol%, and even more preferably 30 mol% or more and less than 85 mol% within one molecule.

The polymer compound having a structural unit represented by any of formulae (1) to (3) may be synthesized in accordance with the synthetic method described in JP-A No. 2003-262958, paragraphs [0027] to [0057]. In particular, the synthetic method 1) described therein is preferred.

Specific examples of the polymer compound having at least one structural unit represented by any of formulae (1) to (3) include the polymer compounds 1 to 17 listed in Tables 1 to 4.

| Polymer compound | Structural unit | Acid value (mg KOH/g) | Mw |
|---|---|---|---|
| 1 | 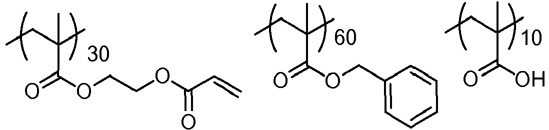 | 33.1 | 97000 |
| 2 | 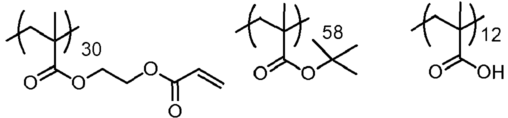 | 45.5 | 31000 |
| 3 | 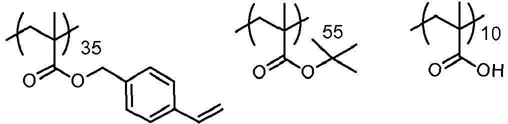 | 35.6 | 50000 |
| 4* | 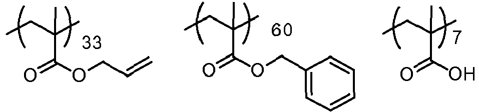 | 25.6 | 18000 |
| 5 | 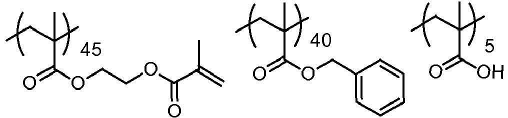 | 17.1 | 30000 |

| | | | |
|---|---|---|---|
| * Polymer compound 4 is mentioned for reference | | | |

| Polymer compound | Structural unit | Acid value (mgKOH/g) | Mw |
|---|---|---|---|
| 6 | 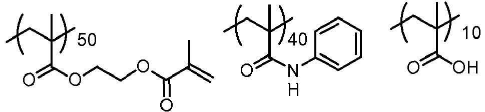 | 32.6 | 11000 |
| 7 | 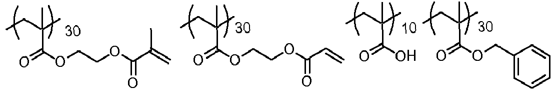 | 31.8 | 75000 |
| 8 | 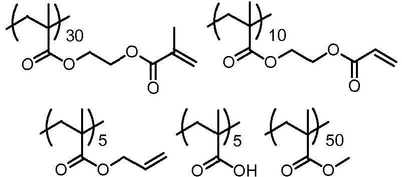 | 20.2 | 40000 |
| 9 | 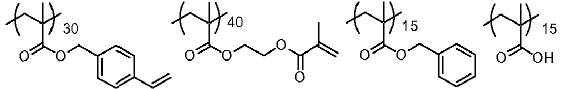 | 46.9 | 55000 |
| 10 | 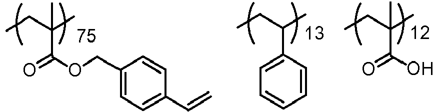 | 38.4 | 25000 |

| Polymer compound | Structural unlit | Acid value (mgKOH/g) | Mw |
|---|---|---|---|
| 11* | 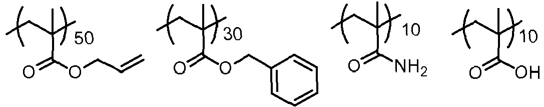 | 42.2 | 34000 |
| 12 | 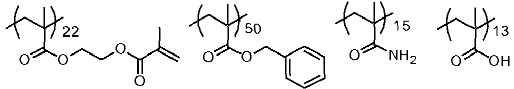 | 46.9 | 7000 |
| 13 | 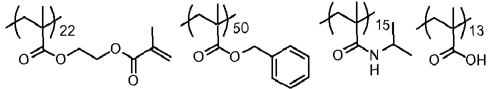 | 45.0 | 23000 |
| 14 | 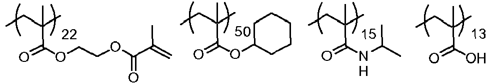 | 46.2 | 31000 |
| 15 | 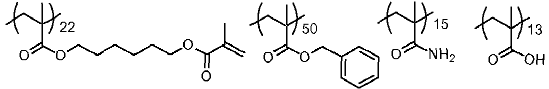 | 43.4 | 59000 |

| | | | |
|---|---|---|---|
| * Polymer compound 11 is mentioned for reference | | | |

| Polymer compound | Structural unit | Acid value (mgKOH/g) | Mw |
|---|---|---|---|
| 16 | 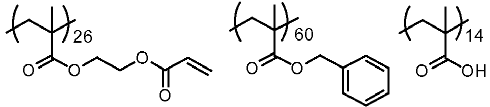 | 47.4 | 72000 |
| 17 | 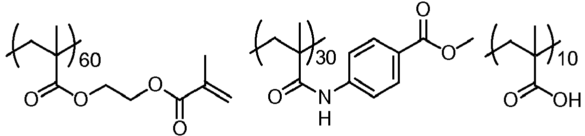 | 29.0 | 90000 |
| 18 | 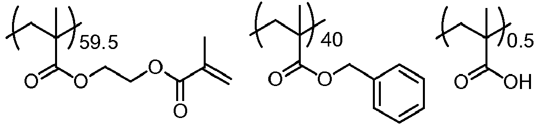 | 1.5 | 50000 |
| 19 | 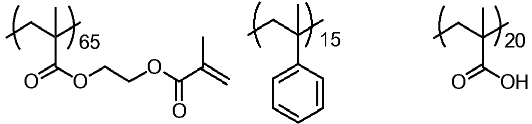 | 69.4 | 300000 |
| 20 | 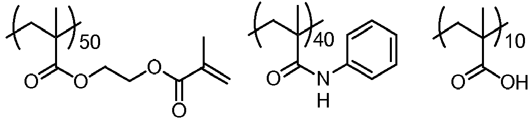 | 32.6 | 320000 |

The resin containing the unsaturated group is preferably a resin obtained by the below-described synthetic method (1) or (2).
(1) A polymer synthesized using the compound represented by formula (4) as a copolymerization component is allowed to react with a base to withdraw protons to release L, and obtain the intended polymer compound having a structure represented by formula (1). 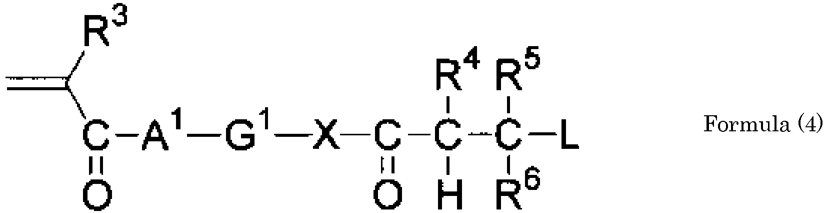 In formula (4), L represents an anionic releasing group, and is preferably, for example, a halogen atom, an alkyl group, or an arylsulfonyloxy group. R³ to R⁶, A¹, G¹, and X are the same as to those in formula (1). The base used to cause the releasing reaction may be an inorganic compound or an organic compound. The details and preferable exemplary embodiments of the method are described in JP-A No. 2003-262958, paragraphs [0028] to [0033].

Preferable examples of the inorganic compound base include sodium hydroxide, potassium hydroxide, sodium carbonate, sodium hydrogen carbonate, potassium carbonate, and potassium bicarbonate, and examples of the organic compound base include metal alkoxide such as sodium methoxide, sodium ethoxide, and potassium t-butoxide, and organic amine compounds such as triethylamine, pyridine, and diisopropyl ethylamine.
(2) A polymer synthesized using the compound represented by formula (5) as a copolymerization component is subjected to base treatment to release the specific functional group thereof, whereby X¹ is released to form a radical reactive group. 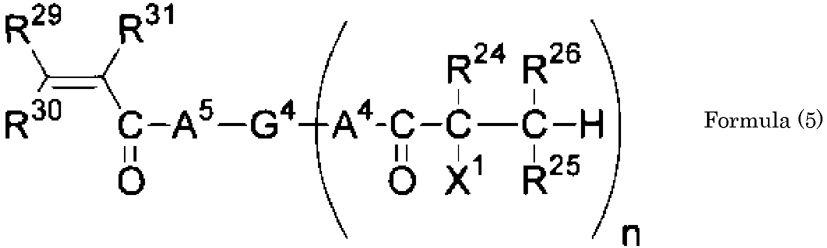 In formula (5), A⁴ represents an oxygen atom, a sulfur atom, or -N(R²⁷)-, A⁵ represents an oxygen atom, a sulfur atom, or -NR²⁸-, R²⁴, R²⁵, R²⁶, R²⁷, R²⁸, R²⁹, R³⁰, and R³¹ each independently represent a hydrogen or a monovalent organic group, X¹ represents a group removed by releasing reaction, and G⁴ represents an organic linking group. n represents an integral number from 1 to 10.

In the invention, in particular, A⁴ is preferably an oxygen atom. R²⁴ is preferably a methyl group, R²⁵, R²⁶, R²⁹, and R³⁰ are preferably hydrogen atoms, and R³¹ is preferably a methyl group or a hydrogen atom. In addition, X¹ is preferably a bromine atom, and G⁴ is preferably an ethylene group.

The details and preferable exemplary embodiments of the method are described in JP-A No. 2003-335814.

Examples of the resin obtained by the synthetic method (2) include polymer compounds described in JP-A No. 2003-335814, and specific preferable examples thereof include (i) polyvinyl polymer compounds, (ii) polyurethane polymer compounds, (iii) polyurea polymer compounds, (iv) poly(urethane-urea) polymer compounds, (V) polyester polymer compounds, (vi) polyamide polymer compounds , (vii) acetal-modified polyvinyl alcohol polymer compounds, and specific compounds obtained in accordance with these descriptions.

Specific examples of the compound represented by formula (4) include the compounds (M-1) to (M-12) listed below, but the invention is not limited to them.

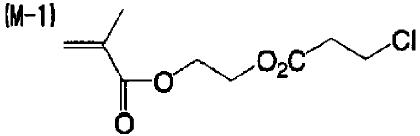

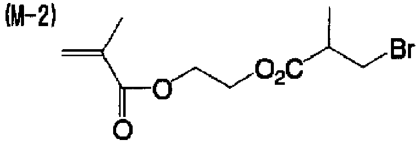

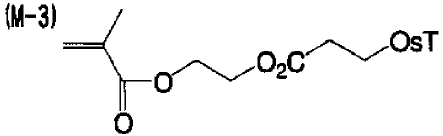

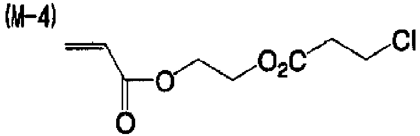

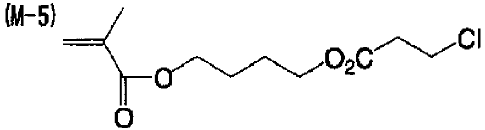

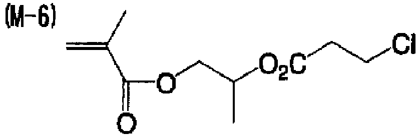

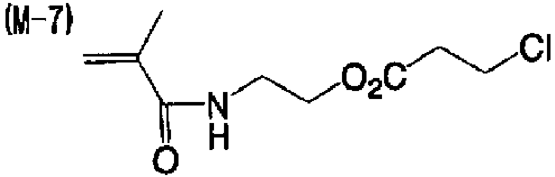

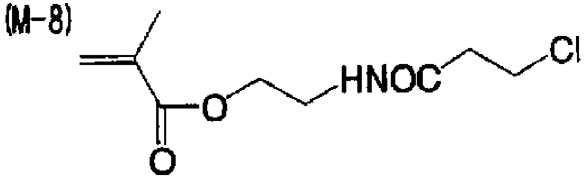

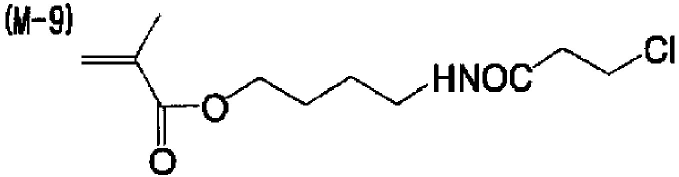

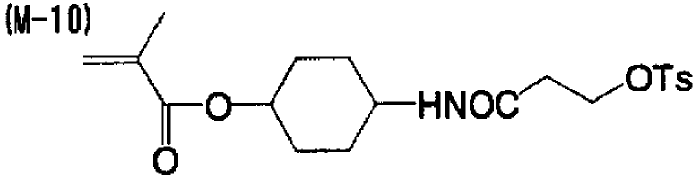

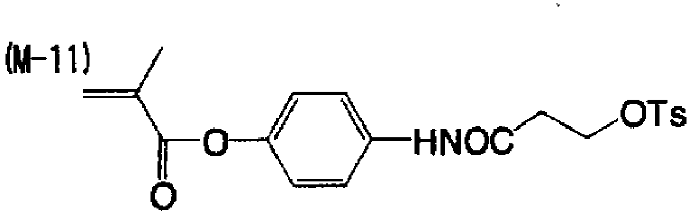

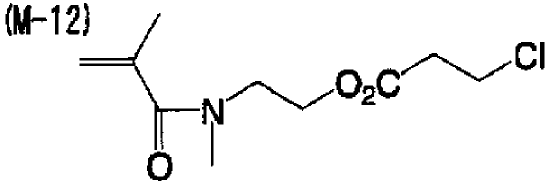

Examples of the compound represented by formula (5) include the compounds (i-1) to (i-52) listed below, but the invention is not limited to them.

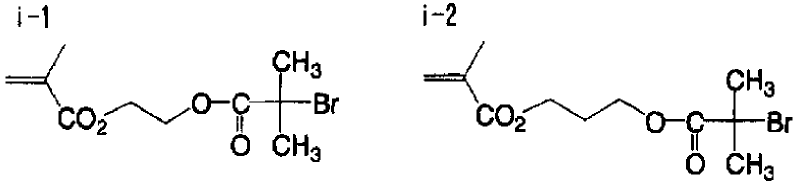

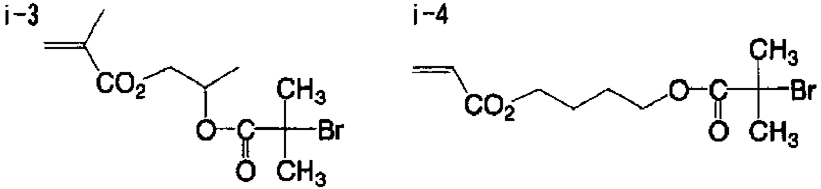

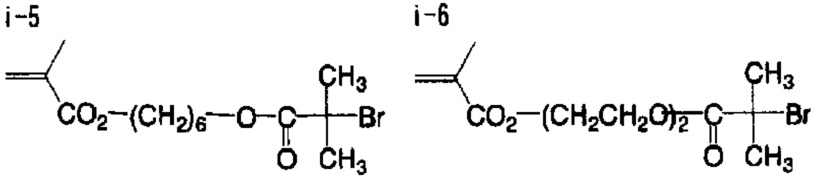

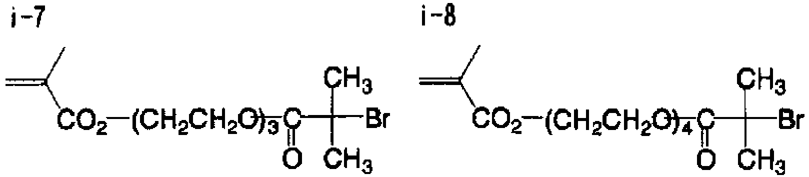

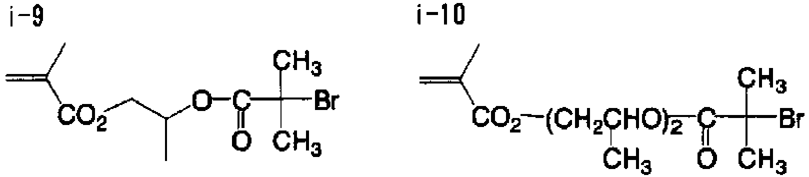

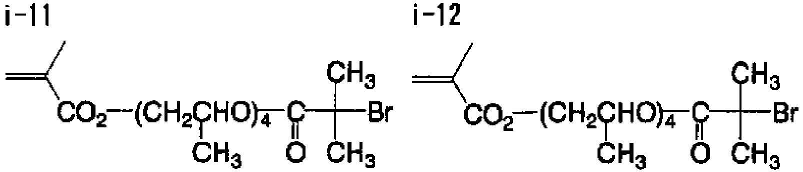

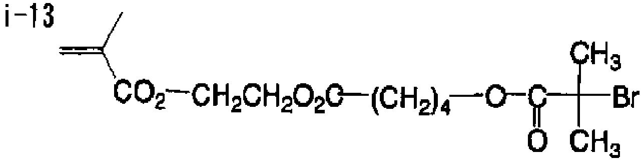

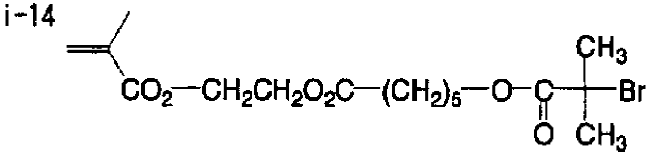

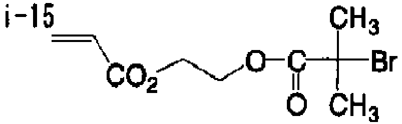

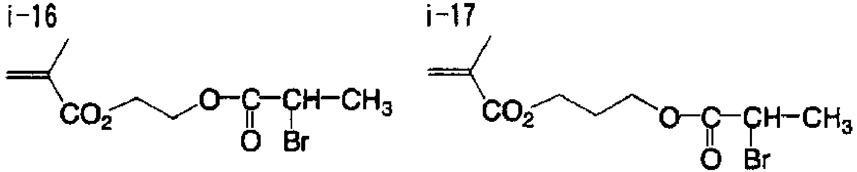

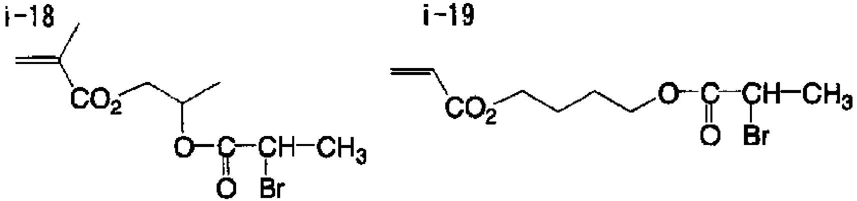

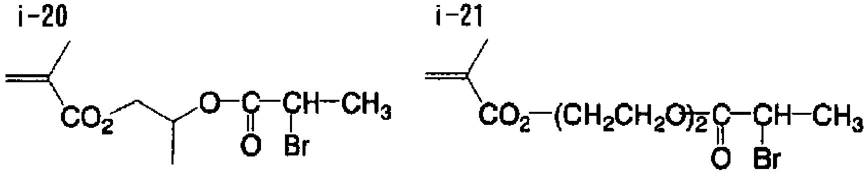

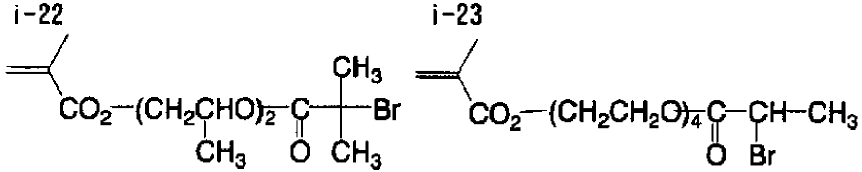

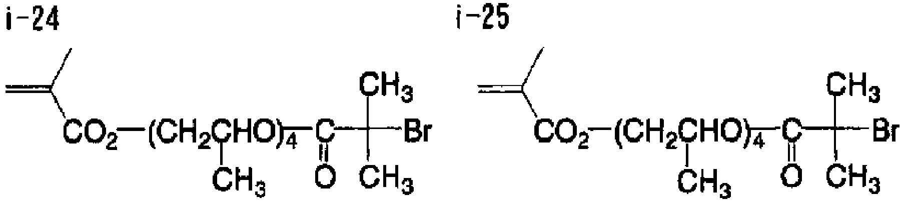

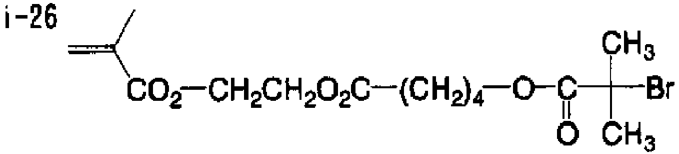

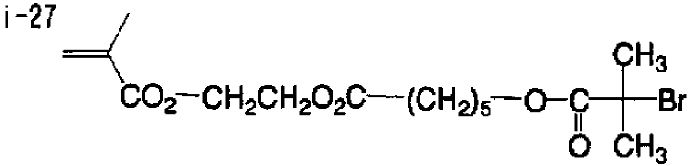

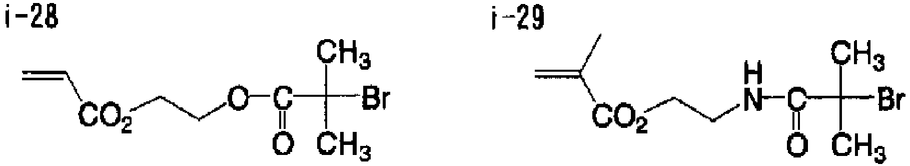

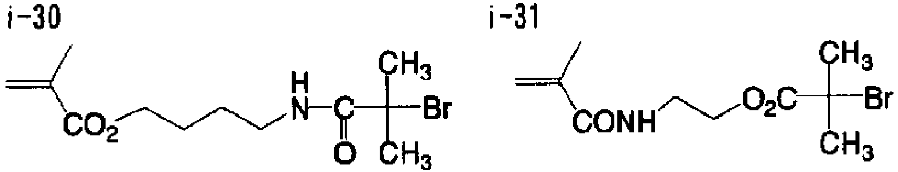

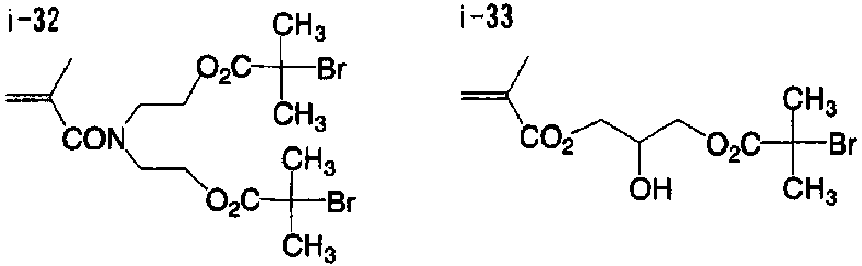

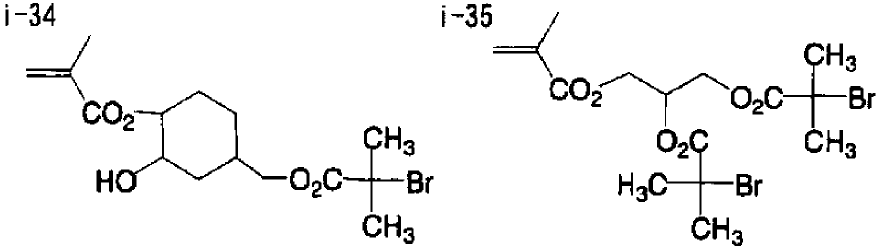

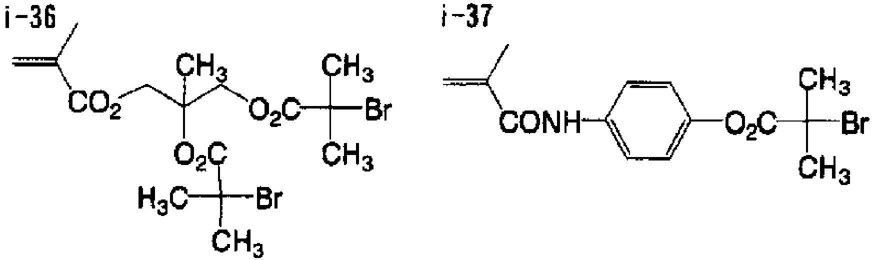

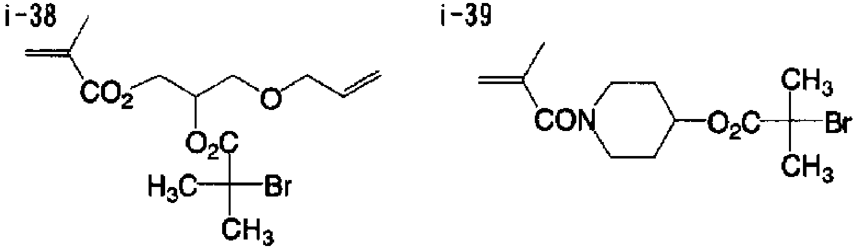

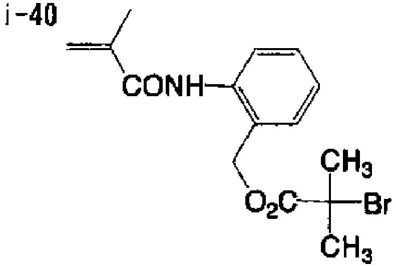

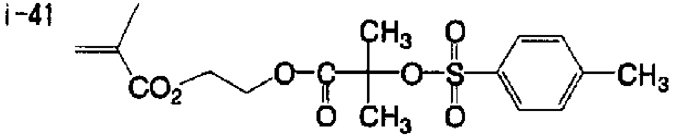

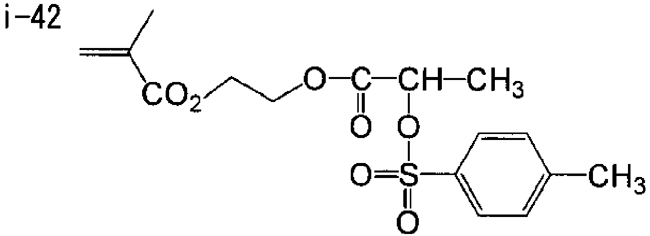

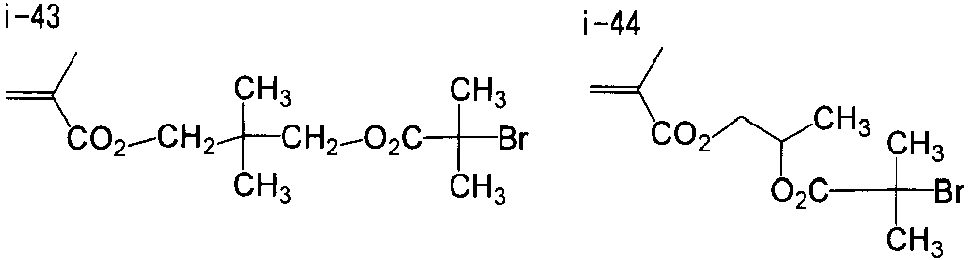

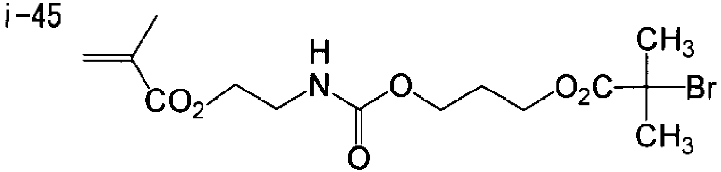

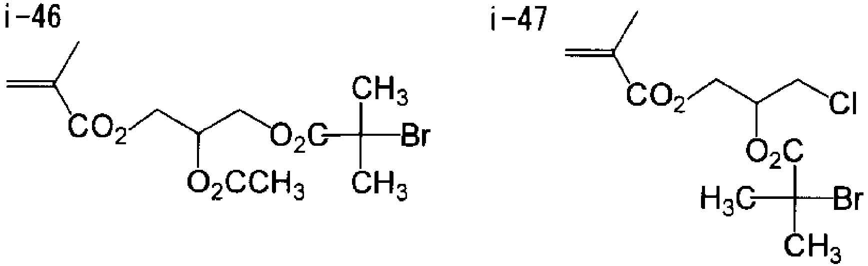

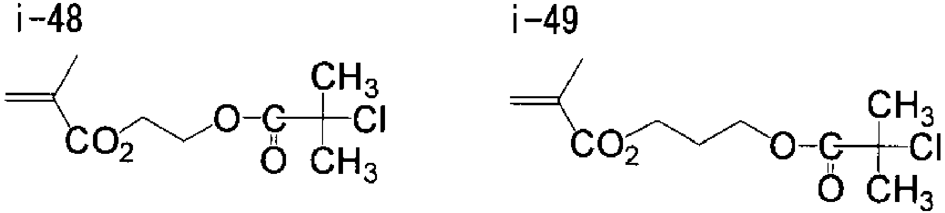

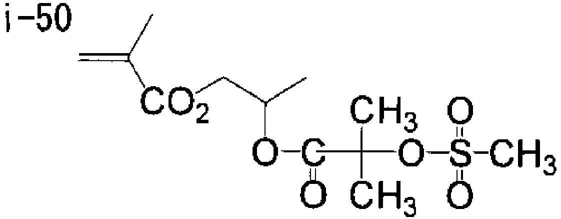

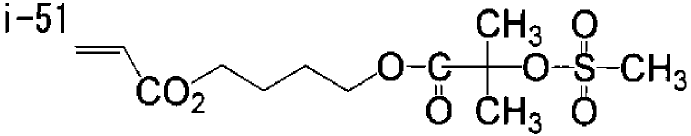

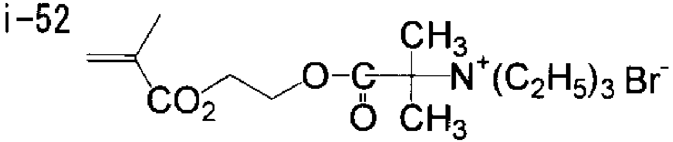

The resin in the invention particularly preferably has a photopolymerizable unsaturated bond from the viewpoint of improving photosensitivity. In addition, from the viewpoint of enabling alkali development, the resin preferably has at least one acid group selected from COOH, SO₃H, PO₃H₂, OSO₃H, and OPO₂H₂. In addition, the acid value of the resin in the invention is from 1 to 70 mg KOH/g, preferably from 5 to 50 mg KOH/g, and more preferably from 10 to 45 mg KOH/g. If the acid value is more than 70 mg KOH/g, peeling of patterns tends to occur during development. On the other hand, if the acid value is less than 1 mg KOH/g, alkali developability deteriorates.

In the invention, the acid value may be calculated, for example, from the average content of acid groups in the resin molecule. A resin having an intended acid value is obtained by changing the content of the monomer unit having the acid group composing the resin.

From the viewpoint of development residues in unexposed areas, the resin in the invention is preferably a copolymer composed of a component containing an amide bond in the resin.

From the viewpoints of developability and preventing peeling of patterns during development, the mass average molecular weight of the resin in the invention is preferably from 30,000 to 300,000, more preferably from 40,000 to 250,000, even more preferably from 50,000 to 200,000, and particularly preferably from 50,000 to 100,000. The mass average molecular weight of the resin may be determined, for example, by GPC.

From the viewpoint of achieving both developability and preventing peeling of the pattern during development, the content of the resin in the colored photosensitive composition of the invention with reference to the total solid content is preferably from 0.01 to 20% by mass, more preferably from 1 to 10% by mass, and even more preferably from 3 to 7% by mass.

### (C) Polymerizable compound

The polymerizable compound (polymerizable monomer) is further described below. The polymerizable monomer is preferably a compound having a boiling point of 100°C or more under normal pressure, and having at least one ethylenic unsaturated group capable of addition polymerization.

Examples of the compound include monofunctional acrylates and metaacrylates such as polyethylene glycol mono(meth)acrylate, polypropylene glycol mono(meth)acrylate, and phenoxyethyl (meth)acrylate; polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate;
(meth)acrylates obtained through addition of ethylene oxide or propylene oxide to a polyfunctional alcohol such as trimethylolpropane tri(acryloyloxypropyl)ether, tri(acryloyloxyethyl) isocyanurate, glycerol, or trimethylolethane; urethane acrylates described in JP-B Nos. 48-41708 and 50-6034, and JP-A No. 51-37193, polyester acrylates described in JP-A No. 48-64183, and JP-B Nos. 49-43191 and 52-30490; and polyfunctional acrylates, metacrylates, and mixtures thereof, such as epoxy acrylates obtained by reaction between an epoxy resin and (meth)acrylic acid. Other examples include photocurable monomers and oligomers described in Journal of the Adhesion Society of Japan Vol. 20, No. 7, p. 300 to 308.

In addition to the above-described compounds, radical polymerizable monomers containing a carboxyl group represented by formulae (III-1) and (III-2) are also preferred. In formulae (III-1) and (III-2), in the case of where T or G is an oxyalkylene group, the end on the carbon atom side combines with R, X, and W 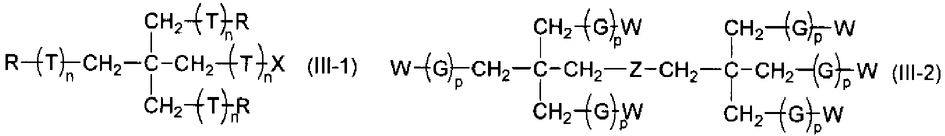 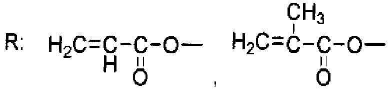 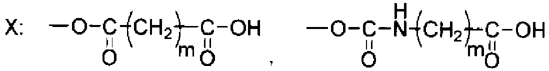 T: -CH₂-, -OCH₂-, -OCH₂CH₂-, -OCH₂CH₂CH₂-, -OCH₂CH₂CH₂CH₂-
G: -H₂-, -OCH₂-, -OCH₂CH₂-, -OCH₂CH₂CH₂-, -OCH₂CH₂CH₂CH₂-

In formula (III-1), n is from 0 to 14, and m is from 1 to 8. In formula (III-2), W is the same meaning as R or X in formula (III-1), wherein three of more of the six Ws are Rs. p is from 0 to 14, and q is from 1 to 8. A plurality of Rs, Xs, Ts, and Gs in one molecule may be the same as or different from each other. Specific examples of the radical polymerizable monomers represented by formulae (III-1) and (III-2) include those represented by the following formulae.

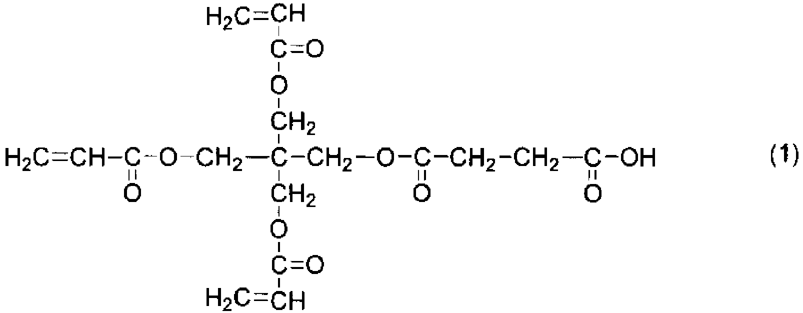

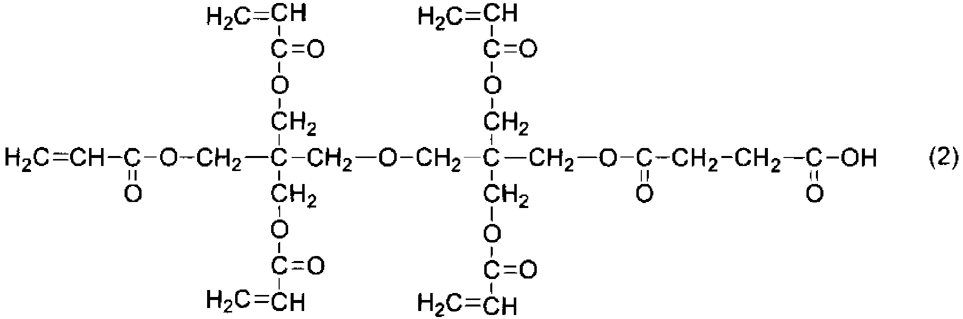

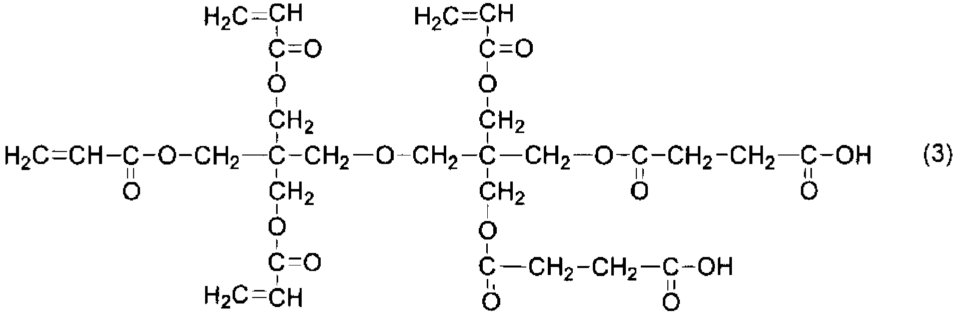

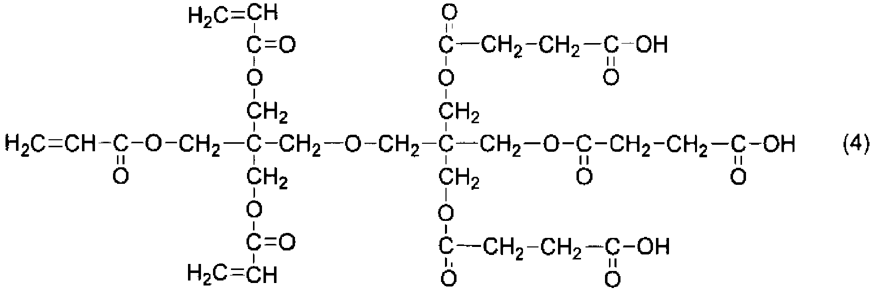

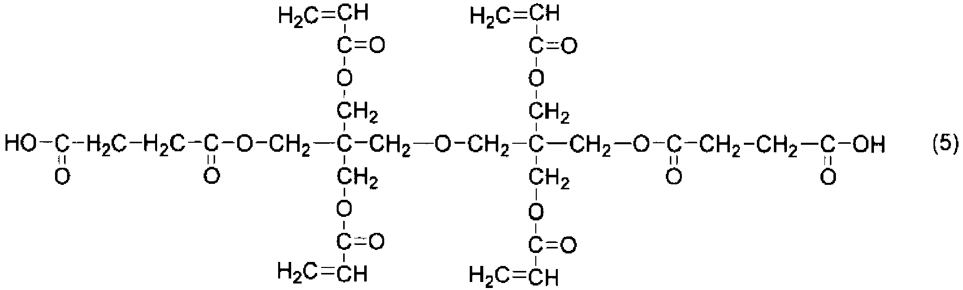

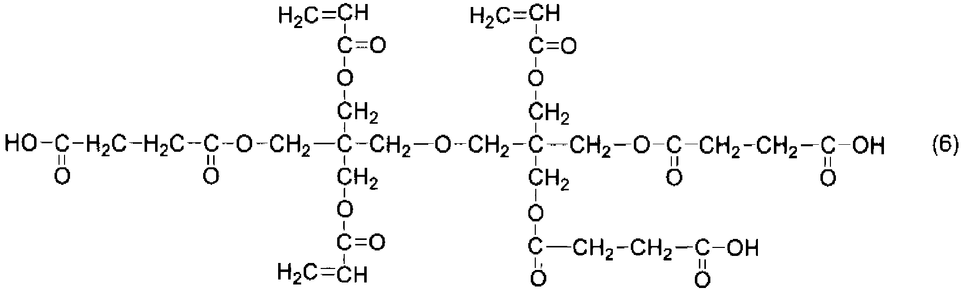

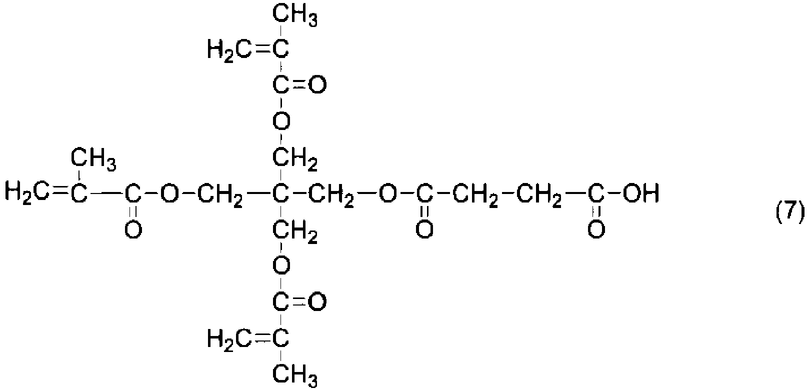

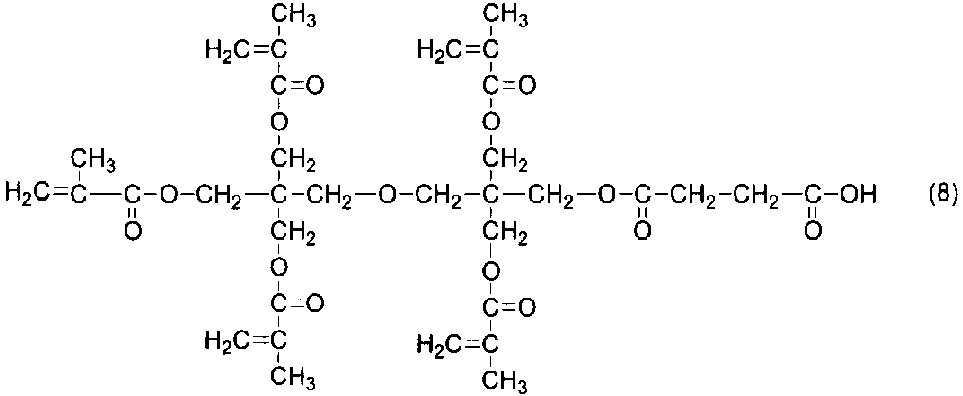

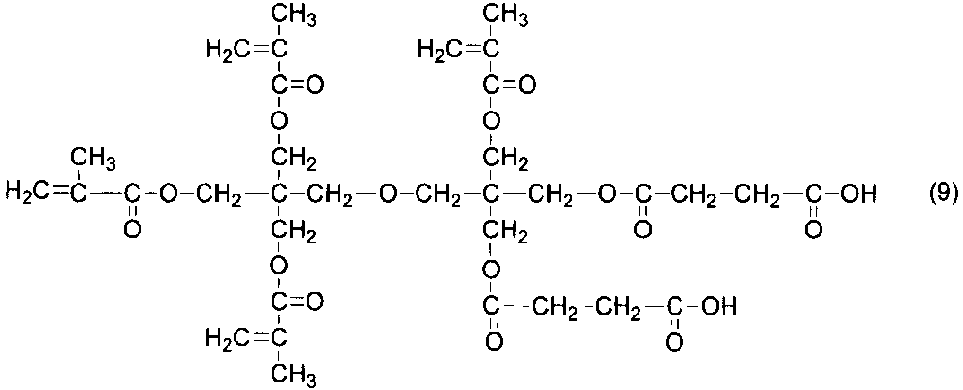

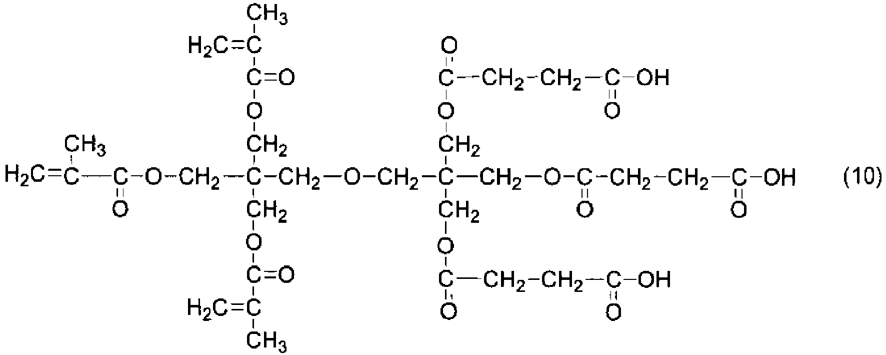

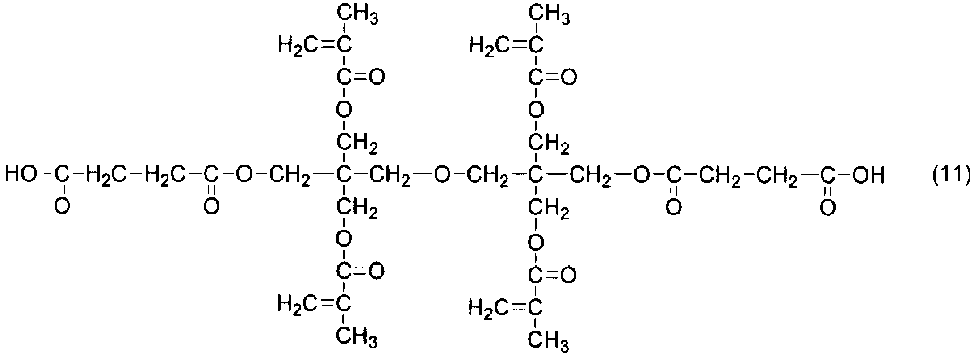

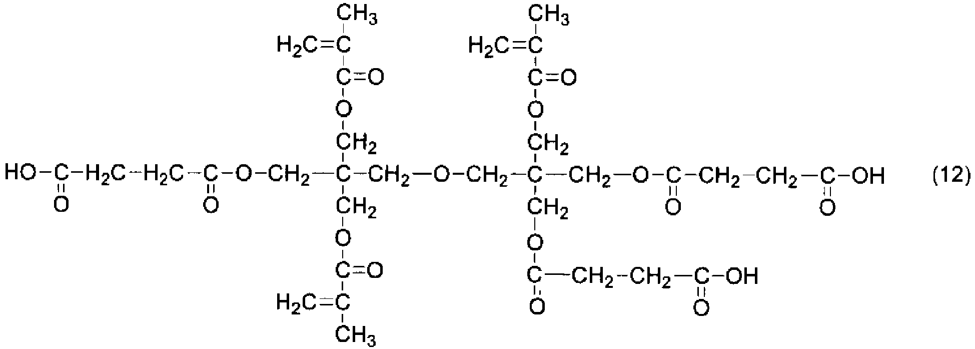

The content of the polymerizable monomer in the colored photosensitive composition is preferably from 10 to 45% by mass, more preferably from 12 to 40% by mass, and particularly preferably from 15 to 35% by mass with reference to the total solid content in the composition. When the content is within the range, sufficient cure in the exposed areas and solubility of the unexposed areas are maintained, and cure of exposed areas can sufficiently be maintained, and extreme reduction in solubility of the unexposed areas can be prevented.

### (Photopolymerization initiator)

The photopolymerization initiator is described below. The colored photosensitive composition preferably contains at least one photopolymerization initiator. The photopolymerization initiator is not particularly limited as long as it is capable of polymerizing a polymerizable monomer, and is preferably selected in consideration of, for example, properties, initiation efficiency, absorption wavelength, availability, and cost. Examples of the photopolymerization initiator include at least one active halogen compound selected from a halomethyloxadiazole compound and a halomethyl-s-triazine compound, a 3-aryl-substituted coumarin compound, a rofin dimer, a benzophenone compound, an acetophenone compound and derivatives thereof, a cyclopentadiene-benzene-iron complex and salts thereof, and an oxime compound.

Examples of the active halogen compound such as halomethyloxadiazole include 2-halomethyl-5-vinyl-1,3,4-oxadiazole compound described in JP-B No. 57-6096, 2-trichloromethyl-5-styryl-1,3,4-oxadiazole, 2-trichloromethyl-5-(p-cyanostyryl)-1,3,4-oxadiazole, and 2-trichloromethyl-5-(p-methoxystyryl)-1,3,4-oxadiazole.

Examples of the photopolymerization initiator of a halomethyl-s-triazine compound include a vinyl-halomethyl-s-triazine compound described in JP-B No. 59-1281, a 2-(naphtho-1-yl)-4,6-bis(halomethyl)-s-triazine compound and a 4-(p-aminophenyl)-2,6-bis(halomethyl)-s-triazine compound described in JP-ANo. 53-133428.

Other examples include 2,4-bis(trichloromethyl)-6-p-methoxystyryl-s-triazine, 2,6-bis(trichloromethyl)-4-(3,4-methylenedioxyphenyl)-1,3,5-triazine, 2,6-bis(trichloromethyl)-4-(4-methoxyphenyl)-1,3,5-triazine, 2,4-bis(trichloromethyl)-6-(1-p-dimethylaminophenyl-1,3-butadienyl)-s-triazine, 2-trichloromethyl-4-amino-6-p-methoxystyryl-s-triazine, 2-(naphtho-1-yl)-4,6-bis(trichloromethyl)-s-triazine, 2-(4-methoxy-naphtho-1-yl)-4,6-bis(trichloromethyl)-s-triazine, 2-(4-ethoxy-naphtho-1-yl)-4,6-bis(trichloromethyl)-s-triazine, 2-(4-butoxy-naphtho-1-yl)-4,6-bis(trichloromethyl)-s-triazine, 2-[4-(2-methoxyethyl)-naphtho-1-yl]-4,6-bis(trichloromethyl)-s-triazine, 2-[4-(2-ethoxyethyl)-naphtho-1-yl]-4,6-bis(trichloromethyl)-s-triazine, 2-[4-(2-butoxyethyl)-naphtho-1-yl]-4,6-bis(trichloromethyl)-s-triazine, 2-(2-methoxy-naphtho-1-yl)-4,6-bis(trichloromethyl)-s-triazine, 2-(6-methoxy-5-methyl-naphtho-2-yl)-4,6-bis(trichloromethyl)-s-triazine, 2-(6-methoxy-naphtho-2-yl)-4,6-bis(trichloromethyl)-s-triazine, 2-(5-methoxy-naphtho-1-yl)-4,6-bis(trichloromethyl)-s-triazine, 2-(4,7-dimethoxy-naphtho-1-yl)-4,6-bis(trichloromethyl)-s-triazine,
2-(6-ethoxy-naphtho-2-yl)-4,6-bis(trichloromethyl)s-triazine, 2-(4,5-dimethoxy-naphtho-1-yl)-4,6-bis(trichloromethyl)s-triazine, 4-[p-N, N-bis(ethoxycarbonylmethyl)aminophenyl]-2,6-bis(trichloromethyl)-s-triazine, 4-[o-methyl-p-N, N-bis(ethoxycarbonylmethyl)aminophenyl]-2,6-bis(trichloromethyl)-s-triazine, 4-[p-N, N-bis(chloroethyl)aminophenyl]-2,6-bis(trichloromethyl)-s-triazine, 4-[o-methyl-p-N, N-bis(chloroethyl)aminophenyl]-2,6-bis(trichloromethyl)-s-triazine, 4-(p-N-chloroethylaminophenyl)-2,6-bis(trichloromethyl)-s-triazine, 4-(p-N-ethoxycarbonylmethylaminophenyl)-2,6-bis(trichloromethyl)-s-triazine, 4-[p-N, N-di(phenyl)aminophenyl]-2,6-bis(trichloromethyl)-s-triazine, 4-(p-N-chloroethylcarbonylaminophenyl)-2,6-bis(trichloromethyl)-s-triazine, 4-[p-N-(p-methoxyphenyl)carbonylaminophenyl]-2,6-bis(trichloromethyl)-s-triazine, 4-[m-N, N-bis(ethoxycarbonylmethyl)aminophenyl]-2,6-bis(trichloromethyl)-s-triazine, 4-[m-bromo-p-N, N-bis(ethoxycarbonylmethyl)aminophenyl]-2,6-bis(trichloromethyl)-s-triazine, 4-[m-chloro-p-N, N-bis(ethoxycarbonylmethyl)aminophenyl]-2,6-bis(trichloromethyl)-s-triazine, 4-[m-fluoro-p-N, N-bis(ethoxycarbonylmethyl)aminophenyl]-2,6-bis(trichloromethyl)-s-triazine,
4-[o-bromo-p-N, N-bis(ethoxycarbonylmethyl)aminophenyl]-2,6-bis(trichloromethyl)-s-triazine, 4-[o-chloro-p-N, N-bis(ethoxycarbonylmethyl)aminophenyl-2,6-bis(trichloromethyl)-s-triazine, 4-[o-fluoro-p-N, N-bis(ethoxycarbonylmethyl)aminophenyl]-2,6-bis(trichloromethyl)-s-triazine, 4-[o-bromo-p-N, N-bis(chloroethyl)aminophenyl]-2,6-bis(trichloromethyl)-s-triazine, 4-[o-chloro-p-N, N-bis(chloroethyl)aminophenyl]-2,6-bis(trichloromethyl)-s-triazine, 4-[o-fluoro-p-N, N-bis(chloroethyl)aminophenyl]-2,6-bis(trichloromethyl)-s-triazine, 4-[m-bromo-p-N, N-bis(chloroethyl)aminophenyl]-2,6-bis(trichloromethyl)-s-triazine, 4-[m-chloro-p-N, N-bis(chloroethyl)aminophenyl]-2,6-bis(trichloromethyl)-s-triazine,
4-[m-fluoro-p-N, N-bis(chloroethyl)aminophenyl]-2,6-bis(trichloromethyl)-s-triazine, 4-(m-bromo-p-N-ethoxycarbonylmethylaminophenyl)-2,6-bis(trichloromethyl)-s-triazine, 4-(m-chloro-p-N-ethoxycarbonylmethylaminophenyl)-2,6-bis(trichloromethyl)-s-triazine, 4-(m-fluoro-p-N-ethoxycarbonylmethylaminophenyl)-2,6-bis(trichloromethyl)-s-triazine, 4-(o-bromo-p-N-ethoxycarbonylmethylaminophenyl)-2,6-bis(trichloromethyl)-s-triazine, 4-(o-chloro-p-N-ethoxycarbonylmethylaminophenyl)-2,6-bis(trichloromethyl)-s-triazine, 4-(o-fluoro-p-N-ethoxycarbonylmethylaminophenyl)-2,6-bis(trichloromethyl)-s-triazine, 4-(m-bromo-p-N-chloroethylaminophenyl)-2,6-bis(trichloromethyl)-s-triazine, 4-(m-chloro-p-N-chloroethylaminophenyl)-2,6-bis(trichloromethyl)-s-triazine, 4-(m-fluoro-p-N-chloroethylaminophenyl)-2,6-di(trichloromethyl)-s-triazine, 4-(o-bromo-p-N-chloroethylaminophenyl)-2,6-bis(trichloromethyl)-s-triazine, 4-(o-chloro-p-N-chloroethylaminophenyl)-2,6-bis(trichloromethyl)-s-triazine, and 4-(o-fluoro-p-N-chloroethylaminophenyl)-2,6-bis(trichloromethyl)-s-triazine.

Other useful examples include TAZ Series manufactured by Midori Kagaku Co., Ltd., such as TAZ-107, TAZ-110, TAZ-104, TAZ-109, TAZ-140, TAZ-204, TAZ-113, and TAZ-123, T Series manufactured by PANCHIM, such as T-OMS, T-BMP, T-R, and T-B, IRGACURE Series and DALOCURE Series manufactured by Ciba Specialty Chemicals, such as IRGACURE 651, IRGACURE 184, IRGACURE 500, IRGACURE 1000, IRGACURE 149, IRGACURE 819, IRGACURE 261, and DALOCURE 11734, 4'-bis(diethylamino)-benzophenone, 2-(o-benzoyloxime)-1-[4-(phenylthio)phenyl]-1,2-octanedione, 2-benzyl-2-dimethylamino-4-morpholino butyrophenone, 2,2-dimethoxy-2-phenylacetophenone, 2-(o-chlorophenyl)-4,5-diphenylimidazolyl dimer, 2-(o-fluorophenyl)-4,5-diphenylimidazolyl dimer, 2-(o-methoxyphenyl)-4,5-diphenylimidazolyl dimer, 2-(p-methoxyphenyl)-4,5-diphenylimidazolyl dimer, 2-(p-dimethoxyphenyl)-4,5-diphenylimidazolyl dimer, 2-(2,4-dimethoxyphenyl)-4,5-diphenylimidazolyl dimer, 2-(p-methylmercaptophenyl)-4,5-diphenylimidazolyl dimer, and benzoin isopropyl ether.

Among the above-described initiator species, oxime compounds are preferred, and 2-(o-benzoyloxime)-1-[4-(phenylthio)phenyl]-1,2-octane dione, and 1-(o-acetyloxime)-1-[9-ethyl-6-(2-methylbenzoyl)-9H-carbazole-3-yl]ethanone are most preferred.

The composition may contain, in addition to the photopolymerization initiator, other known photopolymerization initiator. Specific examples thereof include the vicinal polyketaldonyl disclosed in U.S. Patent No. 2,367,660, the α-carbonyl compounds disclosed in U.S. Patent Nos. 2,367,661 and 2,367,670, the acyloin ether disclosed in U.S. Patent No. 2,448,828, the aromatic acyloin compound substituted by α-hydrocarbon disclosed in U.S. Patent No. 2,722,512, the polynuclear quinone compounds disclosed in U.S. Patent Nos. 3,046,127 and 2,951,758, the combination of a triallylimidazole dimer and p-aminophenyl ketone disclosed in U.S. Patent No. 3,549,367, and the benzothiazole compound and trihalomethy-s-triazine compound disclosed in JP-B No. 51-48516.

These photopolymerization initiators may be combined with a sensitizer and a photostabilizer. Specific examples thereof include benzoin, benzoinmethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9, 10-anthraquinone, xanthone, 2-methyl xanthone, 2-methoxyxanthone, 2-methoxyxanthone, thioxanthone, 2,4-diethylthioxanthone, acridone, 10-butyl-2-chloroacridone, benzyl, dibenzal acetone, p-(dimethylamino)phenylstyryl ketone, p-(dimethylamino)phenyl-p-methylstyryl ketone, benzophenone, p-(dimethylamino)benzophenone (or Michler ketone), p-(diethylamino)benzophenone, benzoanthrone, the benzothiazole compound described in JP-B No. 51-48516, TINUVIN 1130, and TINUVIN 400.

The amount of the photopolymerization initiator to be used is preferably from 1.0% by mass to 40.0% by mass, more preferably from 2.5% by mass to 30.0% by mass, and particularly preferably from 5.0% by mass to 20.0% by mass with reference to the total solid content. If the amount of the photopolymerization initiator is less than 1.0% by mass, polymerization does not proceed smoothly, and if more than 40.0% by mass, the degree of polymerization increases but the molecular weight decreases, which may result in the decrease in the film strength.

The composition preferably contains, in addition to the above-described agents, a heat polymerization inhibitor. Useful examples thereof include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and 2-mercaptobenzoimidazole.

### (Solvent)

The colored photosensitive composition preferably contains a solvent. The solvent is not particularly limited as long as the solubility of components and coating property of the composition are satisfied, and is preferably selected in consideration of, in particular, solubility of dyes and binders, coating property, and safety. Preferable examples of the solvent used to prepare the composition include: esters such as ethylacetate, n-butyl acetate, isobutyl acetate, amyl formate, isoamyl acetate, isobutyl acetate, butyl propionate, isopropyl propionate, ethyl butyrate, butyl butyrate, alkyl esters, oxymethyl acetate, oxyethyl acetate, oxybutyl acetate, methoxymethyl acetate, methoxyethyl acetate, methoxybutyl acetate, ethoxymethyl acetate, ethoxyethyl acetate,
methyl 3-oxypropionate, ethyl 3-oxypropanoate, methyl 3-methoxypropionate, ethyl 3-methoxypropanoate, methyl 3-ethoxypropionate, ethyl 3-ethoxypropionnate, methyl 2-oxypropionate, ethyl 2-oxypropanoate, propyl 2-oxypropionate, methyl 2-methoxypropionate, ethyl 2-methoxypropanoate, propyl 2-methoxypropionate, methyl 2-ethoxypropionate, ethyl 2-ethoxypropionnate, methyl 2-oxy-2-methylpropionate, ethyl 2-oxy-2-methylpropanoate, methyl 2-methoxy-2-methyl propionate, ethyl 2-ethoxy-2-methylpropanoate, methyl pyruvate, ethyl pyruvate, propyl pyruvate, methyl pyruvate, ethyl acetoacetate, methyl 2-oxobutanoate, and ethyl 2-oxobutanoate;
ethers such as diethylene glycol dimethyl ether, tetrahydrofuran, ethylene glycol monomethyl ether, ethylene glycol monoethyl ether, methyl cellosolve acetate (ethylene glycol monomethyl ether acetate), ethyl cellosolve acetate (ethylene glycol monoethyl ether acetate), diethylene glycol monomethyl ether, diethylene glycol monoethyl ether, diethylene glycol monobutyl ether, diethylene glycol monoethyl ether acetate, diethylene glycol monobutyl ether acetate, propylene glycol methyl ether, propylene glycol methyl ether acetate, propylene glycol ethyl ether acetate, and propylene glycol propyl ether acetate; ketones such as methyl ethyl ketone, cyclohexanone, 2-heptanone, and 3-heptanone; and aromatic hydrocarbons such as toluene and xylene.

Among them, 3-methyl ethoxypropionate, 3-ethyl ethoxypropionnate, ethyl cellosolve acetate, ethyl lactate, diethylene glycol dimethyl ether, butyl acetate, methyl 3-methoxypropionate, 2-heptanone, cyclohexanone, ethylcarbitol acetate (diethylene glycol monoethyl ether acetate), butylcarbitol acetate (diethylene glycol monobutyl ether acetate), propylene glycol methyl ether, and propylene glycol methyl ether acetate are more preferred.

The composition may contain various additives as necessary, such as a filler, polymer compound other than the above-described ones, a surfactant, an adhesion promoting agent, an antioxidant, an ultraviolet absorber, and an aggregation inhibitor.

Specific examples of the additives include: a filler such as glass or alumina; a polymer compound other than binder resins, such as polyvinyl alcohol, polyacrylic acid, polyethylene glycol monoalkyl ether, or polyfluoroalkyl acrylate; a nonionic, cationic, or anionic surfactant; an adhesion promoting agent such as vinyltrimethoxysilane, vinyltriethoxysilane, vinyltris(2-methoxyethoxy)silane, N-(2-aminoethyl)-3-aminopropylmethyldimethoxysilane, N-(2-aminoethyl)-3-aminopropyltrimethoxysilane, 3-aminopropyltriethoxysilane, 3-glycidoxypropyltrimethoxysilane, 3-glycidoxypropylmethyldimethoxysilane, 2-(3,4-epoxycyclohexyl)ethyltrimethoxysilane, 3-chloropropylmethyldimethoxysilane, 3-chloropropyltrimethoxysilane, 3-methacryloxypropyltrimethoxysilane, or 3-mercaptopropyltrimethoxysilane; an antioxidant such as 2,2-thiobis(4-methyl-6-t-butylphenol) and 2,6-di-t-butylphenol; an ultraviolet absorber such as 2-(3-t-butyl-5-methyl-2-hydroxyphenyl)-5-chlorobenzotriazole and alkoxybenzophenone; and an aggregation inhibitor such as sodium polyacrylate.

In order to promote alkali solubility of unexposed areas thereby improving developability of the composition the composition may contain an organic carboxylic acid, preferably organic carboxylic acid having a molecular weight as low as 1000 or less. Specific examples thereof include: aliphatic monocarboxylic acids such as acetic acid, propionic acid, butyric acid, valeric acid, pivalic acid, caproic acid, diethylacetic acid, enanthic acid, and caprylic acid; aliphatic dicarboxylic acids such as oxalic acid, malonic acid, succinic acid, glutaric acid, adipic acid, pimelic acid, suberic acid, azelaic acid, sebacic acid, brasylic acid, methylmalonic acid, ethylmalonic acid, dimethylmalonic acid, methylsuccinic acid, tetramethylsuccinic acid, and citraconic acid; aliphatic tricarboxylic acids such as tricarballylic acid, aconitic acid, and camphoronic acid; aromatic monocarboxylic acids such as benzoic acid, toluic acid, cumic acid, hemellitic acid, and mesitylenic acid; aromatic polycarboxylic acids such as phthalic acid, isophthalic acid, terephthalic acid, trimellitic acid, trimesic acid, mellophanic acid acid, and pyromellitic acid; and other carboxylic acid such as phenylacetic acid, hydroxyatropic acid, hydrocinnamic acid, mandelic acid, phenylsuccinic acid, atropic acid, cinnamic acid, cinnamylideneacetic acid, coumaric acid, and umbellic acid.

### (Color filter and method for making the same)

The color filter of the invention is formed by use of the colored photosensitive composition of the invention. The method for making the color filter of the invention may include: applying the colored photosensitive composition of the invention onto a support by, for example, rotary coating, cast coating, or roll coating thereby forming a colored photosensitive composition layer; exposing the colored photosensitive composition layer with light through a predetermined mask pattern and developing the colored photosensitive composition layer with a developing solution to form a color pattern. The method for making the color filter of the invention may include, as necessary, curing the resist pattern by heating and/or exposure. The radiation used herein is particularly preferably ultraviolet light such as g-line, h-line, or i-line.

Examples of the support include soda glass used in liquid crystal display devices, borosilicate glass such as PYREX (registered trademark), quartz glass, and these glasses having a transparent conductive film, and photoelectric conversion device substrates used in an image pick up element, such as a silicon substrate and a complementary metal oxide semiconductor (CMOS). These supports may have black stripes for isolating respective pixels. As necessary, these supports may have thereon an undercoat layer for improving adhesion with the upper layer, preventing diffusion of substances, or planarizing the substrate surface.

The developing solution used to make the color filter of the invention may be any composition as long as it dissolves the composition of the invention and does not dissolve the exposed areas to radiation. Specific examples thereof include combinations of various organic solvents and aqueous alkaline solutions. Examples of the organic solvent include the above-described solvents used for preparing the composition of the invention.

The aqueous alkaline solution may be, for example, an aqueous alkaline solution containing from 0.001 to 10% by mass, preferably from 0.01 to 1% by mass of an alkaline compound such as sodium hydroxide, potassium hydroxide, sodium carbonate, sodium silicate, sodium metasilicate, ammonia water, ethylamine, diethylamine, dimethylethanolamine, tetramethylammonium hydroxide, tetraethylammonium hydroxide, choline, pyrrole, piperidine, or 1,8-diazabicyclo-[5.4.0]-7-undecene. In the case of where a developing solution composed of such an aqueous alkaline solution is used, the developing solution is washed away after development.

The color filter of the invention may be used in liquid crystal display devices and solid-state image pickup devices such as and CCDs, and is particularly suitable for high resolution CCDs and CMOS devices having more than 100,0000 pixels. The color filter of the invention is useful as, for example, a color filter for CCD, wherein the color filter is disposed between the light receiving portions of the pixels for forming the CCD and the microlens for condensing light.

### EXAMPLES

The present invention is further described below in detail with reference to the following examples, but the invention is not limited to the following examples.

"Part" is based on mass unless otherwise noted.

### (Example 1)

### 1) Preparation of resist liquid

Propylene glycol monomethyl ether acetate (PGMEA) 19.20 parts
Ethyl lactate 36.67 parts
Resin 30.51 parts
[40% PGMEA solution of benzyl methacrylate/methacrylic acid/methacrylic acid-2-hydroxyethyl copolymer (molar ratio = 60:22:18)] 12.20 parts
Dipentaerythritol hexaacrylate 12.20 parts (photopolymerizable compound)
Polymerization inhibitor (p-methoxyphenol) 0.0061 parts
Fluorine surfactant (trade name: F-475, manufactured by Dainippon Ink and Chemicals, Incorporated) 0.83 parts
Photopolymerization initiator 0.586 parts
(Trade name: TAZ-107, manufactured by Midori Kagaku Co., Ltd., trihalomethyl triazine photopolymerization initiator)

Above ingredients were mixed and dissolved to make a resist liquid.

### 2) Making of silicon wafer substrate having undercoat layer

A 6-inch silicon wafer was heated in an oven at 200°C for 30 minutes. Subsequently, the resist liquid was applied onto the silicon wafer to give a dry film thickness of 1 µm, dried in an oven at 220°C for 1 hour to form an undercoat layer, and thus a silicon wafer substrate having an undercoat layer was obtained.

### 3)Preparation of colored photosensitive composition (the composition used in the invention)

The compounds of the following composition A-1 were mixed and dissolved to make a colored photosensitive resin composition A-1.

### (Composition A-1)

Cyclohexanone 80 parts
Coloring agent A (above-described exemplary compound C-25) 8.16 parts
Coloring agent B (below-described exemplary compound a) 3.84 parts
KARAYAD DPHA (polymerizable compound manufactured by Nippon Kayaku Co., having an undercoat layer was obtained.

### 3)Preparation of colored photosensitive composition (the composition used in the invention)

The compounds of the following composition A-1 were mixed and dissolved to make a colored photosensitive resin composition A-1.

### (Composition A-1)

Cyclohexanone 80 parts
Coloring agent A (above-described exemplary compound C-25) 8.16 parts
Coloring agent B (below-described exemplary compound a) 3.84 parts
KARAYAD DPHA (polymerizable compound manufactured by Nippon Kayaku Co., Ltd.) 4.91 parts
Photopolymerization initiator 1.50 parts
(Trade name: CGI-242, manufactured by Ciba Specialty Chemicals) Resin (above-described polymer compound 15) 0.98 parts
Dicyclohexylmethylamine 0.61 parts
Surfactant (Trade name: F-781, manufactured by Dainippon Ink and Chemicals, Incorporated) 0.02 parts

### 4) Application, exposure, and development of colored photosensitive composition

The colored photosensitive resin composition A-1 prepared as described in 3) was applied onto the undercoat layer of the silicon wafer substrate having an undercoat layer obtained as described in 2), whereby a photocurable coating film was formed. The coating film was prebaked on a hot plate at 100°C for 120 seconds to give a dry film having a thickness of 0.6 µm. Subsequently, the coating film was irradiated with light using an i-line stepper exposure device (Trade name: FPA-3000i5+, manufactured by Canon. Inc.) at a wavelength of 365 nm through an island pattern mask with a 1.2 µm square pattern in exposure amounts of from 100 to 2500 mJ/cm² with the amount increased in increments of 100 mJ/cm². Subsequently, the silicon wafer substrate having an irradiated coating film was placed on a horizontal rotary table of a spin-shower developing machine (model: DW-30, manufactured by Chemitronics Co.), and subjected to paddle development at 23°C for 60 seconds using CD-2000 (manufactured by Fuji Film Electronic Materials Co., Ltd.), whereby a color pattern was formed on the silicon wafer substrate.

The silicon wafer substrate having the color pattern was fixed on the horizontal rotary table with a vacuum chuck system. While the silicon wafer substrate was rotated by a rotator at a rotation speed of 50 rpm, the substrate was rinsed with a shower of pure water supplied from a jet nozzle above the center of rotation, and then spray-dried to make a color
A: Unexposed areas are completely removed.
B: Residue occurs at acceptable level.
C: Residue occurs at unacceptable level.
D: Significant residue occurs at unacceptable level.

### Examples 2 to 13, Comparative examples 1 to 4

Color filters were made in the same manner as Example 1, except that the colored photosensitive composition A-1 was replaced with colored photosensitive compositions A-2 to A-17 containing the coloring agents and the resins listed in Table 1, and the minimum exposure amount (mJ/cm²) necessary for adhering all portions of the pattern after development and developability of the unexposed areas were evaluated.

| [Table 1] | Colored photosensitive composition | Coloring agents | | | Resin | | | Minimum exposure amount (mJ/cm²) | Developability of unexposed areas |
|---|---|---|---|---|---|---|---|---|---|
| | | Coloring agent A | Coloring agent B | Content of coloring agents | Structure | Acid value (mg KOH/g) | Mass average molecular weight | | |
| Example 1 | A-1 | C-25 | a | 60% | Polymer compound 15 | 43.4 | 59,000 | 200 | A |
| Example 2 | A-2 | C-5 | b | 60% | Polymer compound 1 | 33.1 | 97,000 | 100 | A |
| Example 3 | A-3 | C-58 | c | 60% | Polymer compound 17 | 29.0 | 90,000 | 100 | A |
| Example 4 | A-4 | C-1 | d | 60% | Polymer compound 3 | 35.6 | 50,000 | 100 | A |
| Example 5 | A-5 | C-6 | f | 60% | Polymer compound 5 | 17.1 | 30,000 | 200 | A |
| Example 6 | A-6 | e | c | 60% | Polymer compound 6 | 32.6 | 11,000 | 400 | A |
| Example 7 | A-7 | e | f | 60% | Polymer compound 7 | 31.8 | 75,000 | 100 | A |
| Example 8 | A-8 | C.I Acid Red 57 | f | 60% | Polymer compound 2 | 45.5 | 31,000 | 300 | A |
| Example 9 | A-9 | C.I Acid Blue 249 | d | 60% | Polymer compound 12 | 46.9 | 7,000 | 400 | A |
| Example 10 | A-11 | C.I Acid Blue 249 | b | 60% | Polymer compound 18 | 1.5 | 50,000 | 100 | A |
| Example 11 | A-12 | C.I Acid Blue 249 | b | 60% | Polymer compound 19 | 69.4 | 300,000 | 300 | A |
| Example 12 | A-13 | C.I Acid Blue 249 | b | 60% | Polymer compound 20 | 32.6 | 320,000 | 100 | B |
| Example 13 | A-14 | C.I. Pigment Green 7 | C.I Pigment Yellow 83 | 60% | Polymer compound 15 | 43.4 | 59,000 | 100 | B |
| Comparative example 1 | A-10 | C.I Acid Blue 249 | b | 60% | g | 33.6 | 30,000 | 500 | A |
| Comparative example 2 | A-15 | C.I Acid Blue 249 | b | 60% | h | 70.9 | 20,000 | 1500 | A |
| Comparative example 3 | A-16 | C.I Acid Blue 249 | b | 60% | i | 0.6 | 50,000 | 100 | D |
| Comparative example 4 | A-17 | C.I Acid Blue 249 | b | 60% | None | - | - | 2500 | A |

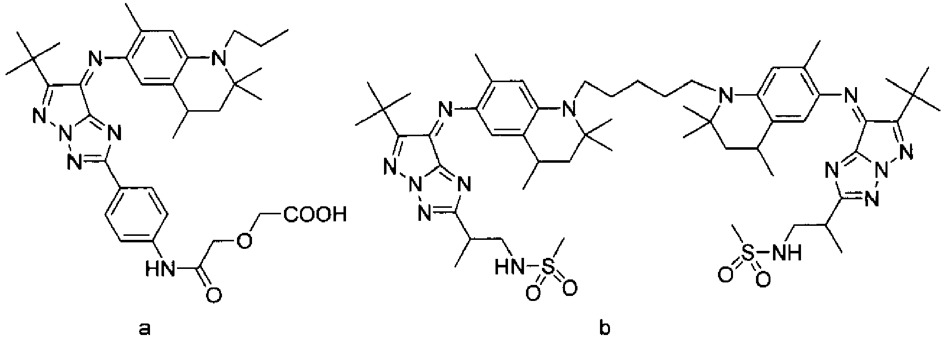

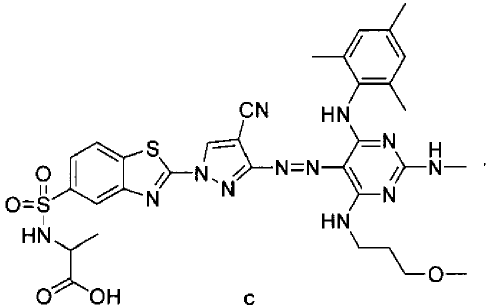

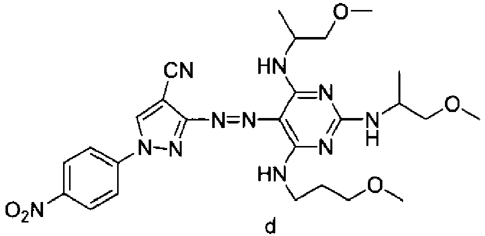

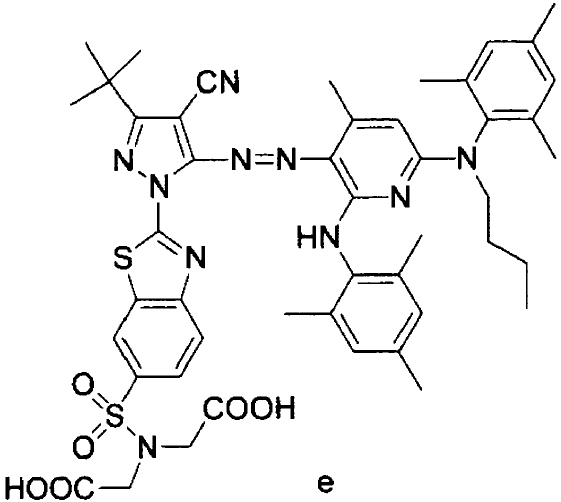

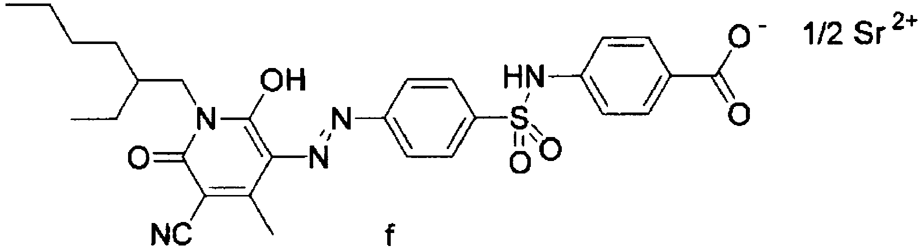

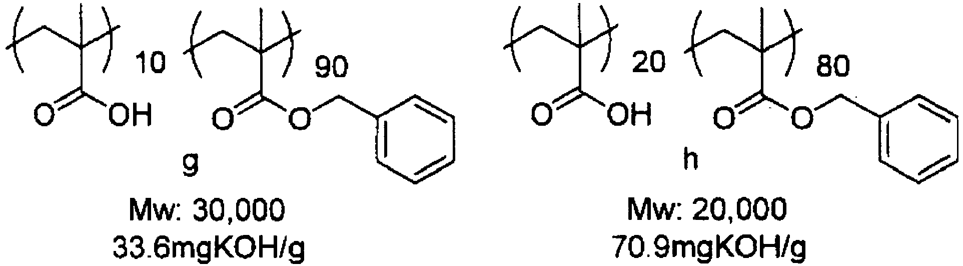

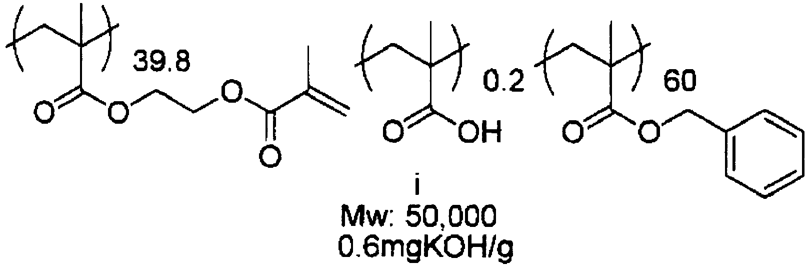

### Examples 14 and 15, Comparative examples 5 to 10

Color filters were made in the same manner as Example 1, except that the colored photosensitive composition A-1 was replaced with colored photosensitive compositions A-18 to A-23 in accordance with Table 2, and the obtained filters were evaluated. The results are summarized in Table 2.

### (Composition A-18)

Cyclohexanone 80 parts
Coloring agent A (above-described exemplary compound C-25) 6.12 parts
Coloring agent B (below-described exemplary compound a) 2.88 parts
KARAYAD DPHA (polymerizable compound manufactured by Nippon Kayaku Co., Ltd.) 7.91 parts
Photopolymerization initiator 1.50 parts
(Trade name: CGI-242, manufactured by Ciba Specialty Chemicals) Resin (above-described polymer compound 15) 0.98 parts
Dicyclohexylmethylamine 0.61 parts
Surfactant (Trade name: F-781, manufactured by Dainippon Ink and Chemicals, Incorporated) 0.02 parts

### (Composition A-19)

Cyclohexanone 80 parts
Coloring agent A (above-described exemplary compound C-25) 6.12 parts
Coloring agent B (below-described exemplary compound a) 2.88 parts
KARAYAD DPHA (polymerizable compound manufactured by Nippon Kayaku Co., Ltd.) 8.89 parts
Photopolymerization initiator 1.50 parts
(Trade name: CGI-242, manufactured by Ciba Specialty Chemicals) Dicyclohexylmethylamine 0.61 parts
Surfactant (Trade name: F-781, manufactured by Dainippon Ink and Chemicals, Incorporated) 0.02 parts

### (Composition A-20)

Cyclohexanone 80 parts
Coloring agent A (above-described exemplary compound C-25) 6.80 parts
Coloring agent B (below-described exemplary compound a) 3.20 parts
KARAYAD DPHA (polymerizable compound manufactured by Nippon Kayaku Co., Ltd.) 6.89 parts
Photopolymerization initiator 1.50 parts
(Trade name: CGI-242, manufactured by Ciba Specialty Chemicals) Resin (above-described polymer compound 15) 0.98 parts
Dicyclohexylmethylamine 0.61 parts
Surfactant (Trade name: F-781, manufactured by Dainippon Ink and Chemicals, Incorporated) 0.02 parts

### (Composition A-21)

Cyclohexanone 80 parts
Coloring agent A (above-described exemplary compound C-25) 6.80 parts
Coloring agent B (below-described exemplary compound a) 3.20 parts
KARAYAD DPHA (polymerizable compound manufactured by Nippon Kayaku Co., Ltd.) 7.87 parts
Photopolymerization initiator 1.50 parts
(Trade name: CGI-242, manufactured by Ciba Specialty Chemicals)
Dicyclohexylmethylamine 0.61 parts
Surfactant (Trade name: F-781, manufactured by Dainippon Ink And Chemicals, Incorporated) 0.02 parts

### (Composition A-22)

Cyclohexanone 80 parts
Coloring agent A (above-described exemplary compound C-25) 10.88 parts
Coloring agent B (below-described exemplary compound a) 5.12 parts
KARAYAD DPHA (polymerizable compound manufactured by Nippon Kayaku Co., Ltd.) 2.37 parts
Photopolymerization initiator 0.50 parts
(Trade name: CGI-242, manufactured by Ciba Specialty Chemicals) Resin (above-described polymer compound 15) 0.50 parts
Dicyclohexylmethylamine 0.61 parts
Surfactant (Trade name: F-781, manufactured by Dainippon Ink And Chemicals, Incorporated) 0.02 parts

### (Composition A-23)

Cyclohexanone 80 parts
Coloring agent A (above-described exemplary compound C-25) 10.88 parts
Coloring agent B (below-described exemplary compound a) 5.12 parts
KARAYAD DPHA (polymerizable compound manufactured by Nippon Kayaku Co., Ltd.) 2.87 parts
Photopolymerization initiator 0.50 parts
(Trade name: CGI-242, manufactured by Ciba Specialty Chemicals) Dicyclohexylmethylamine 0.61 parts
Surfactant (Trade name: F-781, manufactured by Dainippon Ink and Chemicals, Incorporated) 0.02 parts

### (Composition A-24)

Cyclohexanone 80 parts
Coloring agent A (above-described exemplary compound C-25) 11.22 parts
Coloring agent B (below-described exemplary compound a) 5.28 parts
KARAYAD DPHA (polymerizable compound manufactured by Nippon Kayaku Co., Ltd.) 1.87 parts
Photopolymerization initiator 0.50 parts
(Trade name: CGI-242, manufactured by Ciba Specialty Chemicals) Resin (above-described polymer compound 15) 0.50 parts
Dicyclohexylmethylamine 0.61 parts
Surfactant (Trade name: F-781, manufactured by Dainippon Ink and Chemicals, Incorporated) 0.02 parts

### (Composition A-25)

Cyclohexanone 80 parts
Coloring agent A (above-described exemplary compound C-25) 11.22 parts
Coloring agent B (below-described exemplary compound a) 5.28 parts
KARAYAD DPHA (polymerizable compound manufactured by Nippon Kayaku Co., Ltd.) 2.37 parts
Photopolymerization initiator 0.50 parts
(Trade name: CGI-242, manufactured by Ciba Specialty Chemicals) Dicyclohexylmethylamine 0.61 parts
Surfactant (trade name: F-781, manufactured by Dainippon Ink and Chemicals, Incorporated) 0.02 parts

**[Table 2]**

| | Colored photosensitive composition | Coloring agents | | | Resin | | | Minimum exposure amount (mJ/cm²) | Developability of unexposed areas |
|---|---|---|---|---|---|---|---|---|---|
| | | Coloring agent A | Coloring agent B | Content of coloring agents | Structure | Acid value (mg KOH/ g) | Mass average molecular weight | | |
| Example 14 | A-20 | C-25 | a | 50% | Polymer compound 15 | 43.4 | 59,000 | 100 | A |
| Example 15 | A-22 | C-25 | a | 80% | Polymer compound 15 | 43.4 | 59,000 | 500 | A |
| Comparative example 5 | A-18 | C-25 | a | 45% | Polymer compound 15 | 43.4 | 59,000 | 100 | C |
| Comparative example 6 | A-19 | C-25 | a | 45% | None | - | - | 300 | A |
| Comparative example 7 | A-21 | C-25 | a | 50% | None | - | - | 700 | A |
| Comparative example 8 | A-23 | C-25 | a | 80% | None | - | - | 2400 | A |
| Comparative example 9 | A-24 | C-25 | a | 82.5% | Polymer compound 15 | 43.4 | 59,000 | 1300 | A |
| Comparative example 10 | A-25 | C-25 | a | 82.5% | None | - | - | >2500 | A |

The results summarized in Tables 1 and 2 indicate that the color patterns formed with the colored photosensitive composition of the invention exhibited good adhesiveness even at a low exposure amount.

However, when the content of the coloring agents in the colored photosensitive composition was increased in accordance with the formulation as described in JP-A No. 2006-276878, the pixel pattern formed using the composition was apt to peel off at a low exposure amount. The tendency was significant particularly for the negative working type photosensitive composition which contained a dye as a coloring agent and was polymerized by radical polymerization.

The invention provides a colored photosensitive composition, a color filter including the colored photosensitive composition, and a method for making the color filter, wherein the colored photosensitive composition prevents the occurrence of peeling off of the pixel pattern during development even at a low exposure amount.

## Claims

1. A color filter, made by applying a colored photosensitive composition onto a support to form a colored photosensitive composition layer; exposing the colored photosensitive composition layer with light through a mask; and developing the exposed colored photosensitive composition layer to form a pattern on the support,
wherein the colored photosensitive composition comprises coloring agent(s) at a ratio of 50% by mass to 80% by mass with reference to the total solid content, and a resin having an acid value of 1 mg KOH/g to 70 mg KOH/g, and
the resin is a polymer compound having at least one unsaturated double bond selected from the structural units represented by the following formulae (1) to (3). 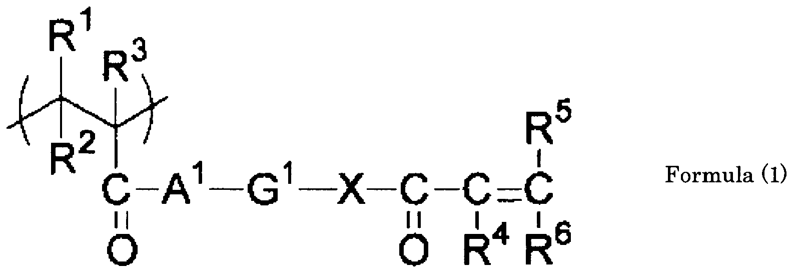 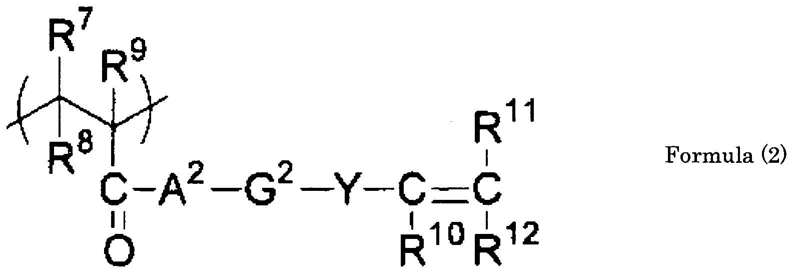 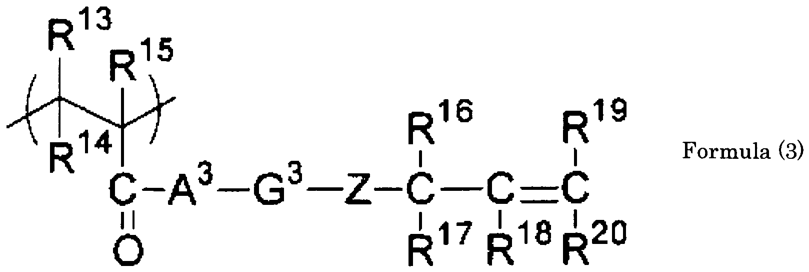 in which A¹, A², and A³ each independently represent an oxygen atom, a sulfur atom, or -N(R²¹)-, wherein R²¹ represents an optionally substituted alkyl group. G¹, G², and G³ each independently represent a divalent organic group, X and Z each independently represent an oxygen atom, a sulfur atom, or -N(R²²)-, wherein R²² represents an optionally substituted alkyl group, Y represents an oxygen atom, a sulfur atom, an optionally substituted phenylene group, or -N(R²³)-, wherein R²³ represents an optionally substituted alkyl group. R¹ to R²⁰ each independently represent a monovalent substituent.

2. The color filter of Claim 1, wherein the mass average molecular weight of the resin is 30,000 to 300,000.

3. The color filter of Claim 1 or 2, which further comprises a polymerizable compound, wherein the colored photosensitive composition is a negative-working composition.

4. The color filter of Claim 1, 2 or 3, wherein all of the coloring agents are organic solvent-soluble dyes

5. The color filter of Claim 4, wherein the coloring agent is represented by the following formula (I) 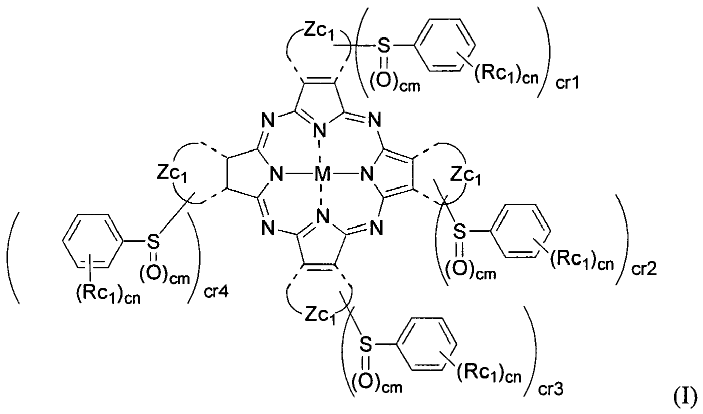 in which Rc₁ represents a halogen atom, an aliphatic group, an aryl group, a heterocyclic group, a cyano group, a carboxyl group, a carbamoyl group, an aliphatic oxycarbonyl group, an aryloxycarbonyl group, an acyl group, a hydroxyl group, an aliphaticoxy group, an aryloxy group, an acyloxy group, a carbamoyloxy group, a heterocyclic oxy group, an aliphatic oxycarbonyloxy group, an N-alkylacylamino group, a carbamoylamino group, a sulfamoylamino group, an aliphatic oxycarbonylamino group, an aryloxycarbonylamino group, an aliphatic sulfonylamino group, an arylsulfonylamino group, an aliphatic thio group, an arylthio group, an aliphatic sulfonyl group, an arylsulfonyl group, a sulfamoyl group, a sulfo group, an imide group, or a heterocyclic thio group; Zc₁ represents a group of nonmetal atoms necessary for forming a six-membered ring with carbon atoms, wherein four Zc₁s may be the same as or different from each other. M represents two hydrogen atoms, a divalent metal atom, a divalent metal oxide, a divalent metal hydroxide, or a divalent metal chloride. cm represents 0, 1, or 2, cn represents 0 or an integral number from 1 to 5, and four cns may be the same or different from each other; at least one cn represents an integral number from 1 to 5, and each Rc₁ in the molecule may be the same as or different from each other; and cr1, cr2, cr3, and cr4 represent 0 or 1, and satisfy the expression cr1 + cr2 + cr3 + cr4 ≥ 1.

6. The color filter of any preceding Claim, in which the colored photosensitive composition further contains an oxime compound.

## Patentansprüche

1. Farbfilter, hergestellt durch Aufbringen einer farbigen lichtempfindlichen Zusammensetzung auf einen Träger, um eine farbige lichtempfindliche Zusammensetzungsschicht zu bilden; Belichten der farbigen lichtempfindlichen Zusammensetzungsschicht mit Licht durch eine Maske; und Entwickeln der belichteten farbigen lichtempfindlichen Zusammensetzungsschicht, um ein Muster auf dem Träger zu bilden,
wobei die farbige lichtempfindliche Zusammensetzung (ein) Färbemittel in einem Verhältnis von 50 Massenprozent bis 80 Massenprozent, bezogen auf den gesamten Feststoffgehalt, und ein Harz mit einer Säurezahl von 1 mg KOH/g bis 70 mg KOH/g umfasst, und
das Harz eine Polymerverbindung mit wenigstens einer ungesättigten Doppelbindung, ausgewählt aus den Struktureinheiten, die durch die folgenden Formeln (1) bis (3) wiedergegeben sind, ist 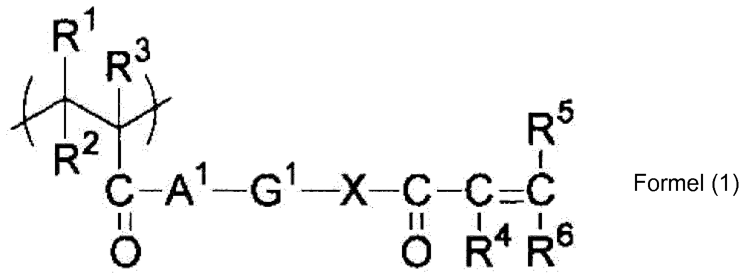 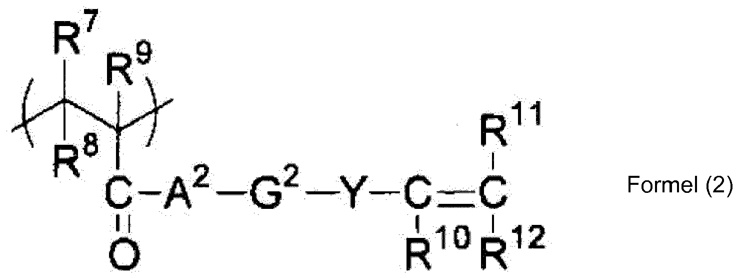 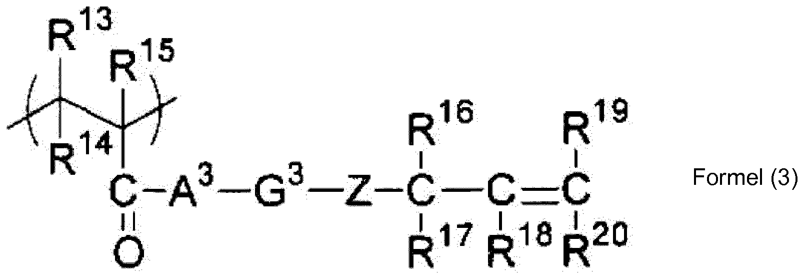 in welchen A¹, A² und A³ jeweils unabhängig ein Sauerstoffatom, ein Schwefelatom oder -N(R²¹)- bedeuten, wobei R²¹ eine gegebenenfalls substituierte Alkylgruppe bedeutet, G¹, G² und G³ jeweils unabhängig eine zweiwertige organische Gruppe bedeuten, X und Z jeweils unabhängig ein Sauerstoffatom, ein Schwefelatom oder -N(R²²)- bedeuten, wobei R²² eine gegebenenfalls substituierte Alkylgruppe bedeutet, Y ein Sauerstoffatom, ein Schwefelatom, eine gegebenenfalls substituierte Phenylengruppe oder -N(R²³)- bedeutet, wobei R²³ eine gegebenenfalls substituierte Alkylgruppe bedeutet, R¹ bis R²⁰ jeweils unabhängig einen einwertigen Substituenten bedeuten.

2. Farbfilter nach Anspruch 1, wobei das massengemittelte Molekulargewicht des Harzes 30000 bis 300000 beträgt.

3. Farbfilter nach Anspruch 1 oder 2, welcher außerdem eine polymerisierbare Verbindung umfasst, wobei die farbige lichtempfindliche Zusammensetzung eine negativ arbeitende Zusammensetzung ist.

4. Farbfilter nach Anspruch 1, 2 oder 3, wobei alle Färbemittel in einem organischen Lösungsmittel lösliche Farbstoffe sind.

5. Farbfilter nach Anspruch 4, wobei das Färbemittel durch die folgende Formel (I) wiedergegeben ist 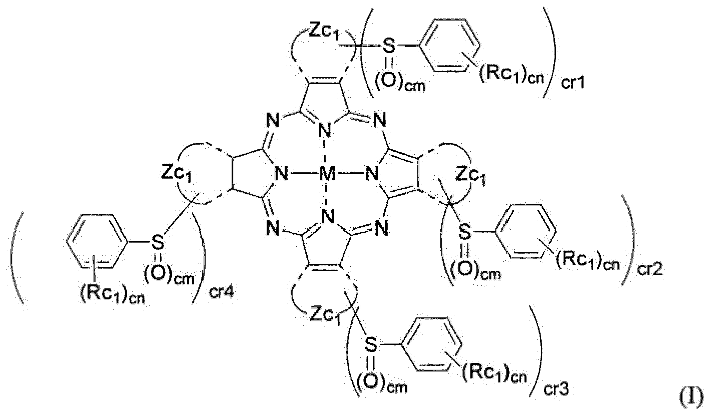 in welcher Rc₁ ein Halogenatom, eine aliphatische Gruppe, eine Arylgruppe, eine heterocyclische Gruppe, eine Cyanogruppe, eine Carboxylgruppe, eine Carbamoylgruppe, eine aliphatische Oxycarbonylgruppe, eine Aryloxycarbonylgruppe, eine Acylgruppe, eine Hydroxylgruppe, eine aliphatische Oxygruppe, eine Aryloxygruppe, eine Acyloxygruppe, eine Carbamoyloxygruppe, eine heterocyclische Oxygruppe, eine aliphatische Oxycarbonyloxygruppe, eine N-Alkylacylaminogruppe, eine Carbamoylaminogruppe, eine Sulfamoylaminogruppe, eine aliphatische Oxycarbonylaminogruppe, eine Aryloxycarbonylaminogruppe, eine aliphatische Sulfonylaminogruppe, eine Arylsulfonylaminogruppe, eine aliphatische Thiogruppe, eine Arylthiogruppe, eine aliphatische Sulfonylgruppe, eine Arylsulfonylgruppe, eine Sulfamoylgruppe, eine Sulfogruppe, eine Imidgruppe oder eine heterocyclische Thiogruppe bedeutet; Zc₁ eine Gruppe von Nichtmetallatomen bedeutet, die zum Bilden eines 6-gliedrigen Rings mit Kohlenstoffatomen erforderlich ist, wobei vier Zc₁-Reste gleich oder voneinander verschieden sein können, M zwei Wasserstoffatome, ein zweiwertiges Metallatom, ein zweiwertiges Metalloxid, ein zweiwertiges Metallhydroxid oder ein zweiwertiges Metallchlorid bedeutet, cm 0, 1 oder 2 bedeutet, cn 0 oder eine ganze Zahl von 1 bis 5 bedeutet und vier cn gleich oder voneinander verschieden sein können; wenigstens ein cn eine ganze Zahl von 1 bis 5 bedeutet, und jedes Rc₁ in dem Molekül gleich oder voneinander verschieden sein kann; und cr1, cr2, cr3 und cr4 0 oder 1 bedeuten und den Ausdruck cr1 + cr2 + cr3 + cr4 ≥ 1 erfüllen.

6. Farbfilter nach einem vorangehenden Anspruch, in welchem die farbige lichtempfindliche Zusammensetzung außerdem eine Oximverbindung enthält.

## Revendications

1. Filtre coloré, préparé en appliquant une composition photosensible colorée sur un support pour former une couche de composition photosensible colorée ; en exposant la couche de composition photosensible colorée à de la lumière à travers un masque ; et en développant la couche de composition photosensible colorée exposée pour former un motif sur le support,
dans lequel la composition photosensible colorée comprend un (des) agent(s) colorant(s) à un rapport de 50 % en masse à 80 % en masse en référence à la matière solide totale, et une résine ayant un indice d'acide de 1 mg KOH/g à 70 mg KOH/g, et
la résine est un composé polymère ayant au moins une double liaison insaturée choisie parmi les motifs structurels représentés par les formules (1) à (3) suivantes : 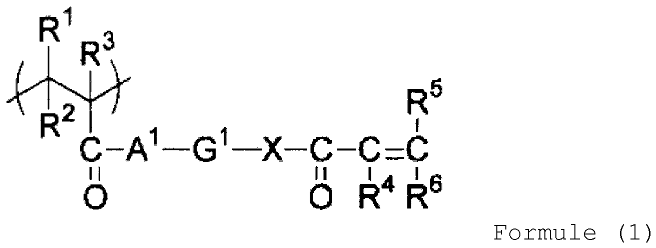 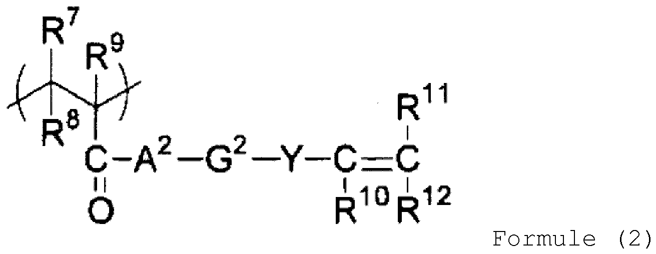 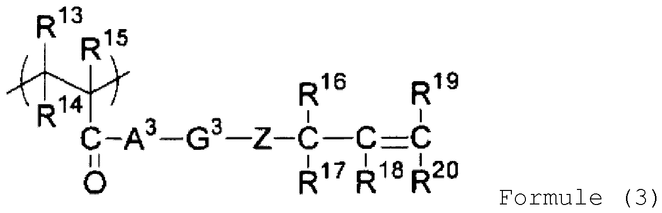 dans lesquelles A¹, A² et A³ représentent chacun indépendamment un atome d'oxygène, un atome de soufre ou -N(R²¹)-, où R²¹ représente un groupe alkyle facultativement substitué, G¹, G² et G³ représentent chacun indépendamment un groupe organique divalent, X et Z représentent chacun indépendamment un atome d'oxygène, un atome de soufre ou -N(R²²)-, où R²² représente un groupe alkyle facultativement substitué, Y représente un atome d'oxygène, un atome de soufre, un groupe phénylène facultativement substitué ou N(R²³)-, où R²³ représente un groupe alkyle facultativement substitué, R¹ à R²⁰ représentent chacun indépendamment un substituant monovalent.

2. Filtre coloré selon la revendication 1, dans lequel la masse moléculaire moyenne en masse de la résine est de 30 000 à 300 000.

3. Filtre coloré selon la revendication 1 ou 2, qui comprend en outre un composé polymérisable, dans lequel la composition photosensible colorée est une composition travaillant en négatif.

4. Filtre coloré selon la revendication 1, 2 ou 3, dans lequel tous les agents colorants sont des teintes solubles dans un solvant organique.

5. Filtre coloré selon la revendication 4, dans lequel l'agent colorant est représenté par la formule (I) suivante 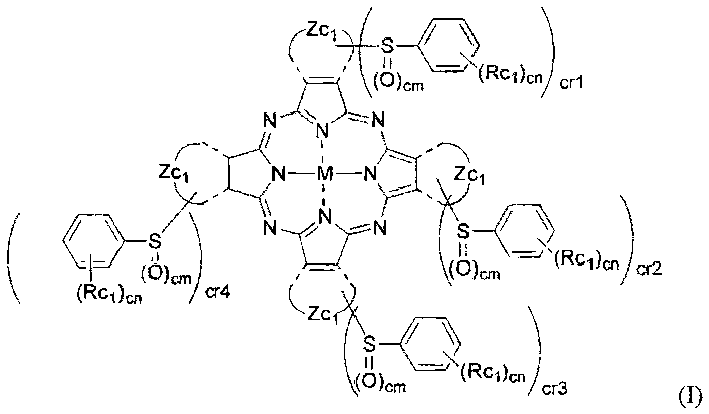 dans laquelle Rc₁ représente un atome d'halogène, un groupe aliphatique, un groupe aryle, un groupe hétérocyclique, un groupe cyano, un groupe carboxyle, un groupe carbamoyle, un groupe oxycarbonyle aliphatique, un groupe aryloxycarbonyle, un groupe acyle, un groupe hydroxyle, un groupe aliphaticoxy, un groupe aryloxy, un groupe acyloxy, un groupe carbamoyloxy, un groupe oxy hétérocyclique, un groupe oxycarbonyloxy aliphatique, un groupe N-alkylacylamino, un groupe carbamoylamino, un groupe sulfamoylamino, un groupe oxycarbonylamino aliphatique, un groupe aryloxycarbonylamino, un groupe sulfonylamino aliphatique, un groupe arylsulfonylamino, un groupe thio aliphatique, un groupe arylthio, un groupe sulfonyle aliphatique, un groupe arylsulfonyle, un groupe sulfamoyle, un groupe sulfo, un groupe imide ou un groupe thio hétérocyclique ; Zc₁ représente un groupe d'atomes non-métal nécessaire pour former un cycle à six chaînons avec des atomes de carbone, où quatre Zc₁ peuvent être identiques ou différents les uns des autres, M représente deux atomes d'hydrogène, un atome de métal divalent, un oxyde de métal divalent, un hydroxyde de métal divalent ou un chlorure de métal divalent, cm représente 0, 1 ou 2, cn représente 0 ou un nombre entier de 1 à 5, et quatre cn peuvent être identiques ou différents les uns des autres ; au moins un cn représente un nombre entier de 1 à 5, et chaque Rc₁ dans la molécule peut être identique ou différent des autres Rc₁ ; et cr1, cr2, cr3 et cr4 représentent 0 ou 1, et satisfont l'expression cr1 + cr2 + cr3 + cr4 ≥ 1.

6. Filtre coloré selon l'une quelconque des revendications précédentes, dans lequel la composition photosensible colorée contient en outre un composé oxime.
